# EUROPEAN PATENT APPLICATION

(11) **EP 4 570 570 A1**
(43) Date of publication of application: **18.06.2025**
(21) Application number: 24218725.0
(22) Date of filing: 10.12.2024
(51) Int. Cl.: B60L 3/12, B60L 53/30, B60L 53/62, B60L 53/66, B60L 53/68, B60L 58/12, B60L 58/16, G01R 31/392, G06N 20/00, G06Q 30/0208, G06Q 50/06, H02J 7/00, B60L 3/00, B60L 53/14, B60L 53/36, B60L 55/00, G01R 31/382

(54) **STRATEGIC DISCHARGING OF VEHICULAR BATTERIES**

(30) Priority: 12.12.2023 US 202318536910
(71) Applicant: Volvo Car Corporation, 405 31 Göteborg (SE)
(72) Inventor: ERIKSSON, Robert Gunnar, 40531 Göteborg (SE); HÄRSJÖ, Joachim John David, 40531 Göteborg (SE); FORSSELL, Jonas, 40531 Göteborg (SE)
(74) Representative: Maiwald GmbH

(57) **Abstract**

Systems/techniques that facilitate strategic discharging of vehicular batteries are provided. In various embodiments, a system can access a charging history of a battery of a vehicle. In various aspects, the system can determine, via execution of a first machine learning model on the charging history, whether the battery is likely to experience expedited degradation. In various instances, the system can recommend, in response to a determination that the battery is likely to experience expedited degradation and via execution of a second machine learning model on the charging history and on a driving history of the vehicle, a discharge routine that is likely to counteract such expedited degradation.

## Description

### TECHNICAL FIELD

The subject disclosure relates generally to electric charging of vehicles, and more specifically to strategic discharging of vehicular batteries.

### BACKGROUND

Many modern vehicles implement fully or partially electric propulsion systems powered by onboard batteries. When the onboard batteries are near depletion, they can be recharged. In practice, drivers often recharge such onboard batteries after only minimal use. Unfortunately, this can cause expedited degradation of the onboard batteries.

Accordingly, systems or techniques that can address one or more of these technical problems can be desirable.

### SUMMARY

The following presents a summary to provide a basic understanding of one or more embodiments of the invention. This summary is not intended to identify key or critical elements, or delineate any scope of the particular embodiments or any scope of the claims. Its sole purpose is to present concepts in a simplified form as a prelude to the more detailed description that is presented later. In one or more embodiments described herein, devices, systems, computer-implemented methods, apparatus or computer program products that facilitate strategic discharging of vehicular batteries are described.

According to one or more embodiments, a system is provided. The system can comprise a non-transitory computer-readable memory that can store computer-executable components. The system can further comprise a processor that can be operably coupled to the non-transitory computer-readable memory and that can execute the computer-executable components stored in the non-transitory computer-readable memory. In various embodiments, the computer-executable components can comprise an access component that can access a charging history of a battery of a vehicle. In various aspects, the computer-executable components can comprise a degradation component that can determine, via execution of a first machine learning model on the charging history, whether the battery is likely to experience expedited degradation. In various instances, the computer-executable components can comprise a discharge component that can recommend, in response to a determination that the battery is likely to experience expedited degradation and via execution of a second machine learning model on the charging history and on a driving history of the vehicle, a discharge routine that is likely to counteract such expedited degradation.

According to one or more embodiments, the above-described system can be implemented as a computer-implemented method or a computer program product.

### DESCRIPTION OF THE DRAWINGS

FIG. 1 illustrates a block diagram of an example, non-limiting system that facilitates strategic discharging of vehicular batteries in accordance with one or more embodiments described herein.
FIG. 2 illustrates a block diagram of an example, non-limiting system including a charging history that facilitates strategic discharging of vehicular batteries in accordance with one or more embodiments described herein.
FIG. 3 illustrates a block diagram of an example, non-limiting system including a first machine learning model and a degradation classification label that facilitates strategic discharging of vehicular batteries in accordance with one or more embodiments described herein.
FIG. 4 illustrates an example, non-limiting block diagram showing how a first machine learning model can generate a degradation classification label in accordance with one or more embodiments described herein.
FIG. 5 illustrates a block diagram of an example, non-limiting system including a driving history, a second machine learning model, and a discharge routine that facilitates strategic discharging of vehicular batteries in accordance with one or more embodiments described herein.
FIG. 6 illustrates an example, non-limiting block diagram showing how a second machine learning model can generate a discharge routine in accordance with one or more embodiments described herein.
FIG. 7 illustrates a flow diagram of an example, non-limiting computer-implemented method that facilitates strategic discharging of vehicular batteries in accordance with one or more embodiments described herein.
FIG. 8 illustrates an example, non-limiting block diagram of a training dataset that can be used to train machine learning models in accordance with one or more embodiments described herein.
FIG. 9 illustrates an example, non-limiting block diagram showing how machine learning models can be trained in accordance with one or more embodiments described herein.
FIG. 10 illustrates a flow diagram of an example, non-limiting computer-implemented method that facilitates strategic discharging of vehicular batteries in accordance with one or more embodiments described herein.
FIG. 11 illustrates a block diagram of an example, non-limiting operating environment in which one or more embodiments described herein can be facilitated.
FIG. 12 illustrates an example networking environment operable to execute various implementations described herein.

### DETAILED DESCRIPTION

The following detailed description is merely illustrative and is not intended to limit embodiments or application/uses of embodiments. Furthermore, there is no intention to be bound by any expressed or implied information presented in the preceding Background or Summary sections, or in the Detailed Description section.

One or more embodiments are now described with reference to the drawings, wherein like referenced numerals are used to refer to like elements throughout. In the following description, for purposes of explanation, numerous specific details are set forth in order to provide a more thorough understanding of the one or more embodiments. It is evident, however, in various cases, that the one or more embodiments can be practiced without these specific details.

Many modern vehicles (e.g., cars, trucks, buses, motorcycles, watercraft, aircraft) implement fully or partially electric propulsion systems. For example, various vehicles are fully electric, such that they are propelled by electric motors rather than internal combustion engines. As another example, various other vehicles are hybrids, such that they are propelled by both electric motors and internal combustion engines working together simultaneously or alternately.

A vehicle having a fully or partially electric propulsion system can have an onboard battery that powers the electric propulsion system. As the vehicle is driven, the onboard battery can near depletion, at which point it can be recharged at a vehicular charging station so that the vehicle can continue being driven.

In practice, a driver of the vehicle can make minimal, little, or otherwise seldom use of the vehicle, such as by driving the vehicle only for a few miles or a few minutes per day and parking the vehicle for the remainder of the day. Such minimal, little, or seldom use of the vehicle can cause the onboard battery to not near depletion. Despite the onboard battery not nearing depletion, the driver can nevertheless recharge the onboard battery. Unfortunately, frequently recharging the onboard battery before the onboard battery has neared depletion (e.g., frequently recharging after only minimal driving) can cause the onboard battery to suffer expedited wear or degradation.

Accordingly, systems or techniques that can address one or more of these technical problems can be desirable.

Various embodiments described herein can address one or more of these technical problems. One or more embodiments described herein include systems, computer-implemented methods, apparatus, or computer program products that can facilitate strategic discharging of vehicular batteries. In other words, various embodiments described herein can leverage artificial intelligence to reduce wear of a vehicular battery caused by charging without being near depletion. In particular, such artificial intelligence can determine whether or not charging habits of the vehicular battery suggest that the vehicular battery is likely to experience expedited wear. If it is determined that the charging habits do suggest that the vehicular battery is likely to experience expedited wear, such artificial intelligence can recommend a periodic or regular discharge routine to counter such expedited wear. That is, such artificial intelligence can be considered strategically or cleverly determining when and how much the vehicular battery should be periodically discharged, so as to slow or reduce the expedited wear indicated by the charging habits. Accordingly, various embodiments described herein can help to prolong the useful life of the vehicular battery.

Various embodiments described herein can be considered as a computerized tool (e.g., any suitable combination of computer-executable hardware or computer-executable software) that can facilitate strategic discharging of vehicular batteries. In various aspects, the computerized tool can comprise an access component, a degradation component, a discharge component, or an execution component.

In various embodiments, there can be a vehicle. In various aspects, the vehicle can comprise an onboard battery that can supply electricity to a fully or partially electric propulsion system of the vehicle. In various instances, the onboard battery can comprise any suitable composition or construction (e.g., can comprise any suitable number of battery cells coupled serially or in parallel with each other, where any of such battery cells can exhibit any suitable chemical or solid-state architectures).

In various embodiments, the access component of the computerized tool can electronically receive or otherwise electronically access a charging history of the vehicle. In some aspects, the access component can electronically retrieve the charging history from any suitable centralized or decentralized data structures (e.g., graph data structures, relational data structures, hybrid data structures), whether remote from or local to the access component. In some instances, the access component can retrieve the charging history from the vehicle itself. In any case, the access component can electronically obtain or access the charging history, such that other components of the computerized tool can electronically interact with (e.g., read, write, edit, copy, manipulate) the charging history.

In various instances, the charging history of the vehicle can be timeseries data indicating how the vehicle was or has been charged in the past (e.g., the charging history can represent how much electricity was stored in the onboard battery at each of various past times or dates, so that the temporal evolution of such stored electricity can be observed; or the charging history can represent past times or dates at which the vehicle entered or exited a charging mode and can represent the respective amounts of electricity stored in the onboard battery at those past times or dates). Thus, the charging history can be indicative of usual or typical charging habits associated with the vehicle. In various aspects, the charging history can be tracked or recorded by any suitable voltage meters or amperage meters that are integrated with the onboard battery.

In various embodiments, the degradation component can electronically store, maintain, control, or otherwise access a first machine learning model. In various aspects, the first machine learning model can exhibit any suitable internal architecture, such as a deep learning neural network internal architecture. For example, the first machine learning model can include any suitable numbers of any suitable types of layers (e.g., input layer, one or more hidden layers, output layer, any of which can be convolutional layers, dense layers, non-linearity layers, pooling layers, batch normalization layers, or padding layers). As another example, the first machine learning model can include any suitable numbers of neurons in various layers (e.g., different layers can have the same or different numbers of neurons as each other). As yet another example, the first machine learning model can include any suitable activation functions (e.g., softmax, sigmoid, hyperbolic tangent, rectified linear unit) in various neurons (e.g., different neurons can have the same or different activation functions as each other). As still another example, the first machine learning model can include any suitable interneuron connections or interlayer connections (e.g., forward connections, skip connections, recurrent connections). However, these are mere non-limiting examples of the first machine learning model. In other cases, the first machine learning model can exhibit any other suitable internal architecture (e.g., support vector machine, naive Bayes, linear regression, logistic regression, decision tree, random forest).

In any case, the first machine learning model can be configured to receive, as input, the charging history and to produce, as output, a degradation classification label. In various aspects, the degradation classification label can be any suitable electronic data that indicates whether or not the onboard battery is likely to have experienced or to be experiencing expedited degradation. In other words, the charging history can be considered as representing how much or how often the vehicle is habitually or typically charged, and the first machine learning model can be configured to infer whether or not such habitual or typical charging is likely to prematurely wear the onboard battery.

As a non-limiting example, if the charging history indicates that the onboard battery is often recharged after having expended a significant portion of electricity (e.g., after the vehicle has been extensively driven), the degradation classification label can indicate that the onboard battery is not likely to experience expedited degradation. On the other hand, if the charging history instead indicates that the onboard battery is often recharged after having expended only a small portion of electricity (e.g., after the vehicle has been driven only minimally or for short total distances), the degradation classification label can indicate that the onboard battery is likely to experience expedited degradation.

As another non-limiting example, if the charging history indicates that the vehicle is often plugged into a vehicular charging station for long periods of time after the onboard battery has reached a full charge, the degradation classification label can indicate that the onboard battery is likely to experience expedited degradation. On the other hand, if the charging history indicates that the vehicle is not often plugged into a vehicular charging station for long periods of time after the onboard battery has reached a full charge, the degradation classification label can indicate that the onboard battery is not likely to experience expedited degradation.

In any case, the charging history can represent how much or how often the onboard battery is typically charged, and the first machine learning model can classify that charging as either likely or not likely to accelerate wear of the onboard battery. In this way, the first machine learning model can be considered as detecting or diagnosing charging patterns that cause accelerated wear.

In response to the degradation classification label indicating that the onboard battery is not likely to experience expedited degradation, the computerized tool can refrain from taking further action. However, in response to the degradation classification label indicating that the onboard battery is likely to experience expedited degradation, the computerized tool can take various actions, as described herein.

In various embodiments, the access component can electronically receive, retrieve, or otherwise access from any suitable source (e.g., from the vehicle itself) a driving history of the vehicle. In various cases, the driving history of the vehicle can be timeseries data indicating how the vehicle was or has been driven at various past times or dates (e.g., how quickly the vehicle was moving, how sharply the vehicle was turning, or how far the vehicle had traveled since a most recent recharge at each of such various past times or date). So, the driving history can be indicative of driving habits or use habits of the vehicle. In various aspects, the driving history of the vehicle can be tracked or recorded by any suitable motion sensors integrated with the vehicle.

In various embodiments, the discharge component can electronically store, maintain, control, or otherwise access a second machine learning model. In various aspects, the second machine learning model can exhibit any suitable internal architecture, such as a deep learning neural network internal architecture. For example, the second machine learning model can include any suitable numbers of any suitable types of layers (e.g., input layer, one or more hidden layers, output layer, any of which can be convolutional layers, dense layers, non-linearity layers, pooling layers, batch normalization layers, or padding layers). As another example, the second machine learning model can include any suitable numbers of neurons in various layers (e.g., different layers can have the same or different numbers of neurons as each other). As yet another example, the second machine learning model can include any suitable activation functions (e.g., softmax, sigmoid, hyperbolic tangent, rectified linear unit) in various neurons (e.g., different neurons can have the same or different activation functions as each other). As still another example, the second machine learning model can include any suitable interneuron connections or interlayer connections (e.g., forward connections, skip connections, recurrent connections). However, these are mere non-limiting examples of the second machine learning model. In other cases, the second machine learning model can exhibit any other suitable internal architecture (e.g., support vector machine, naive Bayes, linear regression, logistic regression, decision tree, random forest).

In any case, the second machine learning model can be configured to receive, as input, the charging history and the driving history and to produce, as output, a recommended discharge routine. In various aspects, the recommended discharge routine can be any suitable electronic data that indicates when and how much electricity should be periodically discharged from the onboard battery in order to address (e.g., slow, prevent, reduce) the accelerated degradation detected by the degradation component. That is, the recommended discharge routine can comprise a recommended time and a recommended amount. The recommended time can be a scalar that represents a periodic, regular, or repeating time or date (e.g., every Tuesday at 4:30pm), and the recommended amount can be a scalar that represents how much electricity (e.g., measured absolutely in terms of watt-hours, or measured relatively in terms of battery percentage) should be discharged from the onboard battery at the recommended time. In some aspects, the recommended time can be predicted or inferred by the second machine learning model to be convenient for the vehicle. For instance, the recommended time can be a time or date at which the vehicle is predicted or inferred to be already plugged into a vehicular charging station (e.g., the charging history can indicate at which times or dates the vehicle is typically docked at a vehicular charging station for charging, and the recommended time can be one of those indicated times or dates). In some cases, the recommended amount can be predicted or inferred by the second machine learning model to balance battery wear reduction with battery readiness. For instance, the recommended amount can be an amount or percentage of electricity which, after being discharged at the recommended time, still leaves the onboard battery with a sufficient amount of electricity so as to be prepared for driving that the vehicle is likely to encounter after the recommended time (e.g., the second machine learning model can ensure that the recommended amount is not too large that the onboard battery is not able to handle the driving speeds or accelerations that the vehicle typically experiences shortly after the recommended time).

Accordingly, the degradation component can determine whether or not the charging habits of the vehicle are likely to prematurely harm the onboard battery, and the discharge component can determine how and when electricity should be discharged from the onboard battery so as to counteract such harm. Accordingly, the degradation component and the discharge component can be considered as working in concert to identify how to prevent the onboard battery from prematurely failing due to poor charging habits.

In various cases, the discharge component can visually render the recommended discharge routine on any suitable electronic display (e.g., on a computer screen of the vehicle, or on a computer screen of a mobile device). Accordingly, an operator of the vehicle can become aware of the recommended discharge routine. In some cases, discharging electricity can be associated with a reward (e.g., a monetary disbursement). In such instances, that reward can be visually rendered alongside the recommended discharge routine, so as to incentivize the operator of the vehicle to follow or abide by the recommended discharge routine.

In various embodiments, the execution component of the computerized tool can perform, facilitate, or otherwise execute any suitable electronic actions based on the recommended discharge routine. For instance, the execution component can implement or perform the recommended discharge routine.

As a non-limiting example, the vehicle can, in some embodiments, be already docked at or plugged into a vehicular charging station when the recommended time transpires. More specifically, the vehicular charging station can comprise a charging cable that can, at the recommended time, be plugged or inserted into a charging port of the vehicle, so as to supply electricity to the onboard battery. In such situations, the execution component can electronically cause the onboard battery to be discharged in accordance with the recommended discharge routine. That is, the execution component can instruct or command the vehicular charging station to route the recommended amount of electricity from the onboard battery.

As another non-limiting example, the vehicle can, in some embodiments, not be already docked at or plugged into the vehicular charging station when the recommended time transpires (or any suitable threshold amount of time before the recommended time transpires). Moreover, the vehicle can be equipped with autonomous driving capabilities. In such situations, the execution component can electronically command or instruct those autonomous driving capabilities, so as to cause, at or shortly before the recommended time, the vehicle to autonomously drive to and dock at the vehicular charging station. Once the vehicle completes such autonomous docking (e.g., once the vehicle autonomously plugs itself into the vehicular charging station), the execution component can electronically cause the onboard battery to be discharged in accordance with the recommended discharge routine (e.g., can instruct or command the vehicular charging station to route the recommended amount of electricity from the onboard battery).

Accordingly, various embodiments described herein can be considered as determining and performing strategic discharging for vehicular batteries, so as to prolong the useful lives of such vehicular batteries.

To help cause the degradation classification label and the recommended discharge routine to be accurate, the first and second machine learning models can, as described herein, undergo any suitable type or paradigm of training (e.g., supervised training, unsupervised training, reinforcement learning).

Various embodiments described herein can be employed to use hardware or software to solve problems that are highly technical in nature (e.g., to facilitate strategic discharging for vehicular batteries), that are not abstract and that cannot be performed as a set of mental acts by a human. Further, some of the processes performed can be performed by a specialized computer (e.g., a deep learning neural network having internal parameters such as convolutional kernels) for carrying out defined tasks related to strategic discharging for vehicular batteries.

For example, such defined tasks can include: accessing, by a device operatively coupled to a processor, a charging history of a battery of a vehicle; determining, by the device and via execution of a first machine learning model on the charging history, whether the battery is likely to experience expedited degradation; and recommending, by the device, in response to a determination that the battery is likely to experience expedited degradation, and via execution of a second machine learning model on the charging history and on a driving history of the vehicle, a discharge routine that is likely to counteract such expedited degradation.

Such defined tasks are not performed manually by humans. Indeed, neither the human mind nor a human with pen and paper can electronically execute machine learning models on charging history data or driving history data so as to determine whether such data indicates premature battery wear and, if so, to determine a battery discharging routine that combats such premature battery wear. Indeed, vehicles, machine learning models (e.g., deep learning neural networks), and batteries are inherently-computerized, hardware-based devices that simply cannot be implemented in any way by the human mind without computers. Accordingly, a computerized tool that can determine, via artificial intelligence, whether charging habits of a vehicular battery are likely to accelerate wear of the vehicular battery and a battery discharging routine that can counteract such accelerated wear is likewise inherently-computerized and hardware-based and cannot be implemented in any sensible, practical, or reasonable way without computers.

Moreover, various embodiments described herein can integrate into a practical application various teachings relating to strategic discharging of vehicular batteries. As explained above, it can be the case that an operator of a vehicle often drives the vehicle only minimally and then promptly recharges an onboard battery of the vehicle. Unfortunately, recharging the onboard battery before the onboard battery is near depletion can unnecessarily shorten the useful life of the onboard battery. In other words, recharging the onboard battery when the onboard battery is already close to its maximum capacity can accelerate wear or degradation of the onboard battery. In still other words, it is possible for the way in which the onboard battery is typically recharged to contribute to premature failure of the onboard battery.

Various embodiments described herein can address or ameliorate various of these technical problems. Specifically, various embodiments described herein can leverage artificial intelligence so as to determine whether or not the recharging habits associated with a vehicular battery are likely to accelerate wear of that vehicular battery. If the recharging habits are determined to contribute to accelerated wear of the vehicular battery, such artificial intelligence can be further leveraged to determine a discharge routine which, if followed, would help to impede, reduce, or slow such accelerated wear of the vehicular battery. Accordingly, various embodiments described herein can be considered as detecting deleterious recharging patterns of the vehicular battery and as recommending a remedial discharging pattern for the vehicular battery. In some aspects, various embodiments described herein can involve automatically performing or implementing the remedial discharging pattern (e.g., via autonomous driving and docking capabilities). In this way, various embodiments described herein can be considered as determining or facilitating intelligent, clever, or strategic discharging of vehicular batteries, so as to prolong the useful lives of those vehicular batteries. Accordingly, various embodiments described herein can help to ameliorate premature battery failures. That is, various embodiments described herein can address various disadvantages suffered by existing techniques. Thus, various embodiments described herein certainly constitute a concrete and tangible technical improvement in the field of electric charging of vehicles. Therefore, various embodiments described herein clearly qualify as useful and practical applications of computers.

Furthermore, various embodiments described herein can control real-world tangible devices based on the disclosed teachings. For example, various embodiments described herein can electronically control (e.g., charge, discharge) real-world vehicular charging stations and real-world vehicular batteries.

It should be appreciated that the herein figures and description provide non-limiting examples of various embodiments and are not necessarily drawn to scale.

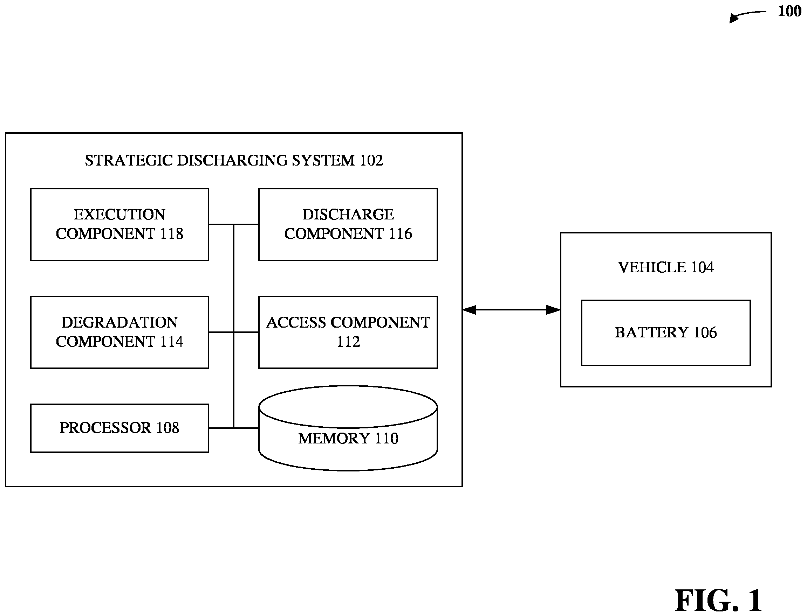

FIG. 1 illustrates a block diagram of an example, non-limiting system 100 that can facilitate strategic discharging of vehicular batteries in accordance with one or more embodiments described herein. As shown, a strategic discharging system 102 can be electronically integrated, via any suitable wired or wireless electronic connection, with a vehicle 104.

In various embodiments, the vehicle 104 can be any suitable vehicle that has a fully electric propulsion system or a partially electric propulsion system. In various aspects, that propulsion system can be electrically powered by a battery 106 that is onboard (e.g., that is physically located on or within) the vehicle 104. In various instances, the battery 106 can have any suitable number of battery cells which can be coupled with each other in any suitable topology or arrangement. As a non-limiting example, some cells of the battery 106 can be coupled together in series with each other, whereas other cells of the battery 106 can be coupled together in parallel with each other. In various cases, any cell of the battery 106 can have or otherwise exhibit any suitable physical construction, make-up, or composition that is rechargeable. As a non-limiting example, any cell of the battery 106 can be any suitable chemical battery cell, such as: a lithium-ion battery cell; an aluminum-ion battery cell; a calcium battery cell; a flow battery cell; a lead-acid battery cell; or an advanced chemistry cell (ACC). As another non-limiting example, any cell of the battery 106 can be any suitable sold-state battery cell, such as: an inorganic solid electrolyte battery cell; a solid polymer electrolyte battery cell; or a quasi-solid-state electrolyte battery cell.

In various aspects, the battery 106 can store electricity so as to power the vehicle 104. In various instances, the battery 106 can expend that stored electricity over time as the vehicle 104 is driven or operated. In various cases, that expended electricity can be replenished by any suitable vehicular charging station (not shown). In various instances, the vehicular charging station can be any suitable station, stall, kiosk, booth, or outlet at which the battery 106 can be charged (also referred to as recharged). In other words, the vehicular charging station can be considered as a distribution access point of any suitable electric grid. In various cases, the vehicle 104 can dock at the vehicular charging station to facilitate such charging. That is, the vehicle 104 can physically drive to and park beside or at the vehicular charging station, a charging cable of the vehicular charging station can be inserted into a charging port of the vehicle 104 (e.g., or equivalently, a charging cable of the vehicle 104 can be inserted into a discharging port of the vehicular charging station), and the vehicular charging station can accordingly route electricity to the battery 106 so as to increase the amount of electricity stored within the battery 106. However, in various aspects, the vehicular charging station can also facilitate discharging of the battery 106. That is, the vehicle 104 can physically drive to and park beside or at the vehicular charging station, a charging cable of the vehicular charging station can be inserted into a charging port of the vehicle 104 (e.g., or equivalently, a charging cable of the vehicle 104 can be inserted into a discharging port of the vehicular charging station), but rather than routing electricity to the battery 106, the vehicular charging station can instead route electricity away from the battery 106 so as to decrease the amount of electricity stored within the battery 106.

In various aspects, it can be possible that however an operator of the vehicle 104 typically charges the battery 106 is likely to cause excessive or accelerated degradation of the battery 106. In various instances, the strategic discharging system 102 can, as described herein, help to ameliorate such excessive or accelerated degradation.

In various embodiments, the strategic discharging system 102 can comprise a processor 108 (e.g., computer processing unit, microprocessor) and a non-transitory computer-readable memory 110 that is operably or operatively or communicatively connected or coupled to the processor 108. The non-transitory computer-readable memory 110 can store computer-executable instructions which, upon execution by the processor 108, can cause the processor 108 or other components of the strategic discharging system 102 (e.g., access component 112, degradation component 114, discharge component 116, execution component 118) to perform one or more acts. In various embodiments, the non-transitory computer-readable memory 110 can store computer-executable components (e.g., access component 112, degradation component 114, discharge component 116, execution component 118), and the processor 108 can execute the computer-executable components.

In various embodiments, the strategic discharging system 102 can comprise an access component 112. In various instances, as described herein, the access component 112 can electronically access a charging history associated with the battery 106.

In various embodiments, the strategic discharging system 102 can comprise a degradation component 114. In various cases, as described herein, the degradation component 114 can electronically determine, via machine learning, whether the charging history suggests that the battery 106 has experienced accelerated wear.

In various embodiments, the strategic discharging system 102 can comprise a discharge component 116. In various cases, as described herein, the discharge component 116 can electronically determine, via machine learning and in response to a determination that the battery 106 is experiencing accelerated wear, a discharge routine that can help to counteract such accelerated wear.

In various embodiments, the strategic discharging system 102 can comprise an execution component 118. In various aspects, as described herein, the execution component 118 can electronically cause the battery 106 to be discharged in accordance with the discharge routine.

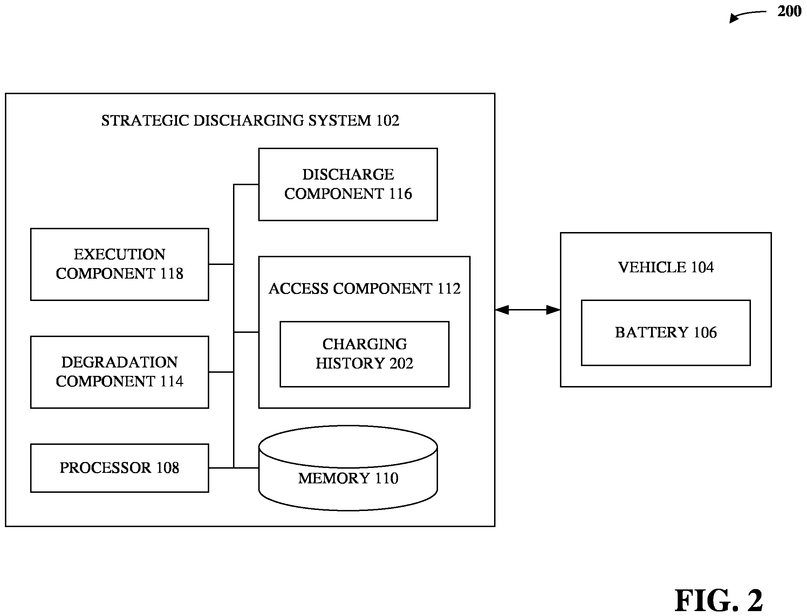

FIG. 2 illustrates a block diagram of an example, non-limiting system 200 including a charging history that can facilitate strategic discharging of vehicular batteries in accordance with one or more embodiments described herein. As shown, the system 200 can, in some cases, comprise the same components as the system 100, and can further comprise a charging history 202.

In various embodiments, the charging history 202 can be one or more scalars, one or more vectors, one or more matrices, one or more tensors, one or more character strings, or any suitable combination thereof that can indicate or otherwise represent how the battery 106 was or has been charged (recharged) in the past.

As a non-limiting example, the charging history 202 can comprise or otherwise be a timeseries showing how much electricity (e.g., which can be measured absolutely in terms of watt-hours, or which can instead be measured relatively in terms of battery percentage) was stored within the battery 106 at each of various past or previous times or dates. Such timeseries can be considered as showing how the total amount of electricity stored within the battery 106 evolved or changed over time, which can be used to infer when and how much the battery 106 was charged in the past. Indeed, past time spans during which the total amount of electricity stored within the battery 106 declined or decreased can be inferred to be instances during which the battery 106 was discharging electricity (e.g., the vehicle 104 can have been driven during such time spans, or the battery 106 can have been discharged at the vehicular charging station during such time spans). In contrast, past time spans during which the total amount of electricity stored within the battery 106 rose or increased can be inferred to be instances during which the battery 106 was being charged with electricity (e.g., the vehicle 104 can have been charged by the vehicular charging station during such past time spans).

As another non-limiting example, the charging history 202 can comprise or otherwise be a timeseries explicitly delineating previous charging sessions undergone by the battery 106. Indeed, in various aspects, the charging history 202 can indicate the times or dates at which those previous charging sessions began (e.g., at which the vehicle 104 was plugged into the vehicular charging station), the times or dates at which those previous charging sessions ended (e.g., at which the vehicle 104 was unplugged from the vehicular charging station), the total amount of electricity stored within the battery 106 at the beginning of each of those previous charging sessions, and the total amount of electricity stored within the battery 106 at the end of each of those charging sessions. In some cases, if the battery 106 was charged to full capacity during any given charging session, the charging history 202 can note or otherwise indicate whether or not the vehicle 104 remained plugged into the vehicular charging station after full capacity was reached during that given charging session. In some instances, if the vehicle 104 remained plugged into the vehicular charging station during any given charging session after having reached full capacity, the charging history 202 can note how long (e.g., seconds, minutes, hours) after reaching full capacity that the vehicle 104 remained plugged into the vehicular charging station.

In any case, the charging history 202 can be considered as representing, indicating, or otherwise conveying how much and how often the battery 106 typically undergoes charging. In other words, the charging history 202 can be considered as showing the charging habits that are associated with the battery 106. In various cases, the charging history 202 can be electronically recorded, electronically tracked, or otherwise electronically generated by any suitable voltage meters, amperage meters, timers, or other electronic sensors that are integrated with the vehicle 104 or with the battery 106.

In various embodiments, the access component 112 can electronically receive or otherwise electronically access the charging history 202. In various instances, the access component 112 can electronically retrieve the charging history 202 from any suitable centralized or decentralized data structures (not shown) or from any suitable centralized or decentralized computing devices (not shown). As a non-limiting example, the vehicle 104 can automatically generate, and continually update, the charging history 202, and the access component 112 can accordingly retrieve the charging history 202 from the vehicle 104. In any case, the access component 112 can electronically obtain or access the charging history 202, such that other components of the strategic discharging system 102 can electronically interact with the charging history 202.

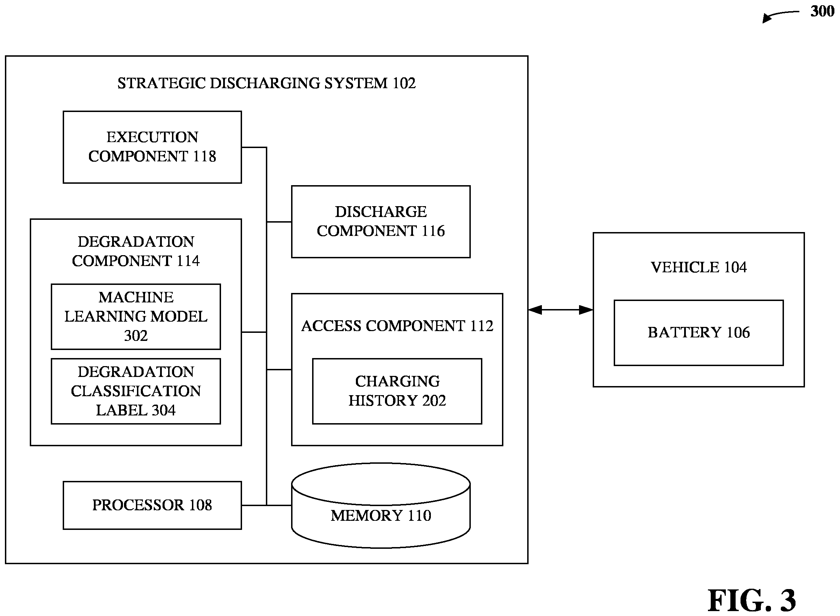

FIG. 3 illustrates a block diagram of an example, non-limiting system 300 including a first machine learning model and a degradation classification label that can facilitate strategic discharging of vehicular batteries in accordance with one or more embodiments described herein. As shown, the system 300 can, in some cases, comprise the same components as the system 200, and can further comprise a machine learning model 302 and a degradation classification label 304.

In various embodiments, the degradation component 114 can electronically store, electronically maintain, electronically control, or otherwise electronically access the machine learning model 302. In various aspects, the machine learning model 302 can have or otherwise exhibit any suitable internal architecture. As a non-limiting example, the machine learning model 302 can have or otherwise exhibit a deep learning internal architecture. For instance, the machine learning model 302 can have an input layer, one or more hidden layers, and an output layer. In various instances, any of such layers can be coupled together by any suitable interneuron connections or interlayer connections, such as forward connections, skip connections, or recurrent connections. Furthermore, in various cases, any of such layers can be any suitable types of neural network layers having any suitable learnable or trainable internal parameters. For example, any of such input layer, one or more hidden layers, or output layer can be convolutional layers, whose learnable or trainable parameters can be convolutional kernels. As another example, any of such input layer, one or more hidden layers, or output layer can be dense layers, whose learnable or trainable parameters can be weight matrices or bias values. As still another example, any of such input layer, one or more hidden layers, or output layer can be batch normalization layers, whose learnable or trainable parameters can be shift factors or scale factors. Further still, in various cases, any of such layers can be any suitable types of neural network layers having any suitable fixed or non-trainable internal parameters. For example, any of such input layer, one or more hidden layers, or output layer can be non-linearity layers, padding layers, pooling layers, or concatenation layers. However, these are mere non-limiting examples. In other aspects, the machine learning model 302 can instead have any other suitable internal architecture, such as a support vector machine architecture, a naive Bayes architecture, or a random forest architecture.

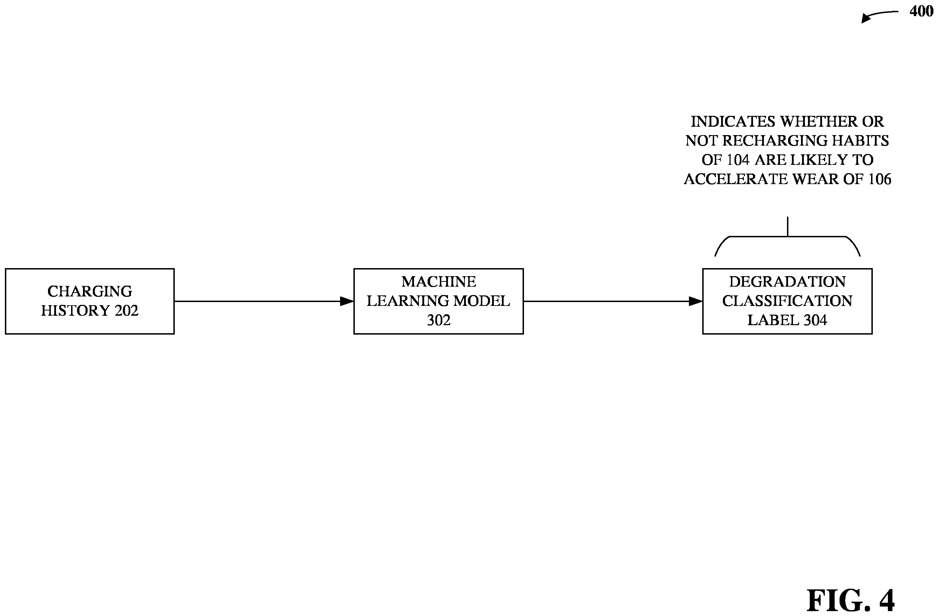

In various aspects, the degradation component 114 can electronically execute the machine learning model 302 on the charging history 202. In various instances, such execution can cause the machine learning model 302 to produce the degradation classification label 304. In various cases, the degradation classification label 304 can be any suitable electronic data that indicates whether or not the charging habits of the battery 106 are likely to accelerate wear, degradation, or damage of the battery 106. Non-limiting aspects are described with respect to FIG. 4.

FIG. 4 illustrates an example, non-limiting block diagram 400 showing how the machine learning model 302 can generate the degradation classification label 304 in accordance with one or more embodiments described herein.

In various instances, the degradation component 114 can execute the machine learning model 302 on the charging history 202. In various cases, such execution can cause the machine learning model 302 to produce the degradation classification label 304. As a non-limiting example, the degradation component 114 can feed the charging history 202 (or a portion thereof) to an input layer of the machine learning model 302. In various instances, the charging history 202 can complete a forward pass through one or more hidden layers of the machine learning model 302. In various cases, an output layer of the machine learning model 302 can compute the degradation classification label 304, based on activation maps or intermediate features produced by the one or more hidden layers of the machine learning model 302.

In any case, the degradation classification label 304 can be one or more scalars, one or more vectors, one or more matrices, one or more tensors, one or more character strings, or any suitable combination thereof that can be considered as specifying or indicating whether the charging habits (recharging habits) of the battery 106 are likely to accelerate or expedite wear, degradation, or damage of the battery 106. Accordingly, the degradation classification label 304 can, in various aspects, be a binary or dichotomous label that indicates one of two possible situations: that the charging history 202 is likely to accelerate wear, degradation, or damage of the battery 106; or that the charging history 202 is unlikely to accelerate wear, degradation, or damage of the battery 106. In other words, the charging history 202 can represent the times at which, the durations for which, or the extents to which the battery 106 typically or usually undergoes charging, and the degradation classification label 304 can indicate whether or not such typical or usual charging behavior is prematurely harming the battery 106.

As a non-limiting example, frequent charging of the battery 106 without the battery 106 having lost a significant amount of electricity can tend to accelerate or hasten wear of the battery 106. This can occur if the vehicle 104 is driven primarily or only for short distances at slow or moderate speeds and then parked or left idle for long periods of time. In contrast, frequent charging of the battery 106 after the battery 106 has lost a significant amount of electricity can be considered as not accelerating or hastening wear of the battery 106. So, suppose that the charging history 202 indicates that charging of the battery 106 is often initiated when the battery 106 is near (e.g., within any suitable threshold margin of) its maximum storage capacity (e.g., charging initiated when the battery 106 is at 90% capacity). In such case, the machine learning model 302 can infer that such charging is likely to expedite wear of the battery 106, and the degradation classification label 304 can indicate so. On the other hand, suppose instead that the charging history 202 indicates that charging of the battery 106 is often initiated when the battery 106 is far from (e.g., beyond any suitable threshold margin of) its maximum storage capacity (e.g., charging initiated when the battery 106 is at 30% capacity). In such case, the machine learning model 302 can infer that such charging is unlikely to expedite wear of the battery 106, and the degradation classification label 304 can indicate so.

As another non-limiting example, leaving the vehicle 104, and thus the battery 106, plugged into the vehicular charging station for an extended amount of time after the battery 106 has been charged to full capacity can tend to accelerate or hasten wear of the battery 106. Indeed, this can be considered as risking that the battery 106 becomes overcharged. In contrast, unplugging the vehicle 104, and thus the battery 106, from the vehicular charging station promptly or soon after the battery 106 has been charged to full capacity can be considered as not accelerating or hastening wear of the battery 106. So, suppose that the charging history 202 indicates that the battery 106 often remains plugged into the vehicular charging station for hours after already having been charged to its maximum capacity. In such case, the machine learning model 302 can infer that such charging is likely to expedite wear of the battery 106, and the degradation classification label 304 can indicate so. On the other hand, suppose instead that the charging history 202 indicates that the battery 106 often remains plugged into the vehicular charging station for no more than mere minutes after having been charged to its maximum capacity. In such case, the machine learning model 302 can infer that such charging is unlikely to expedite wear of the battery 106, and the degradation classification label 304 can indicate so.

In this way, the charging history 202 can be interpreted as representing the real-world charging patterns or charging behavior encountered or experienced by the battery 106, and the degradation classification label 304 can specify whether or not such real-world charging patterns or behavior are prematurely shortening the useful life of the battery 106.

In various aspects, the strategic discharging system 102 can refrain from taking any further electronic actions, in response to the degradation classification label 304 indicating that the battery 106 is not experiencing accelerated wear. Alternatively, in response to the degradation classification label 304 indicating that the battery 106 is not experiencing accelerated wear, the degradation component 114 can wait for the charging history 202 to be updated by the vehicle 104 (e.g., the charging history 202 can change over time as the vehicle 104 is used and as the battery 106 experiences new charging cycles), and the degradation component 114 can execute the machine learning model 302 on the updated version of the charging history 202 (e.g., this can be considered as checking whether or not those new charging cycles are accelerating wear of the battery 106).

In contrast, the discharge component 116 can take various electronic actions as described herein, in response to the degradation classification label 304 indicating that the battery 106 is experiencing accelerated wear.

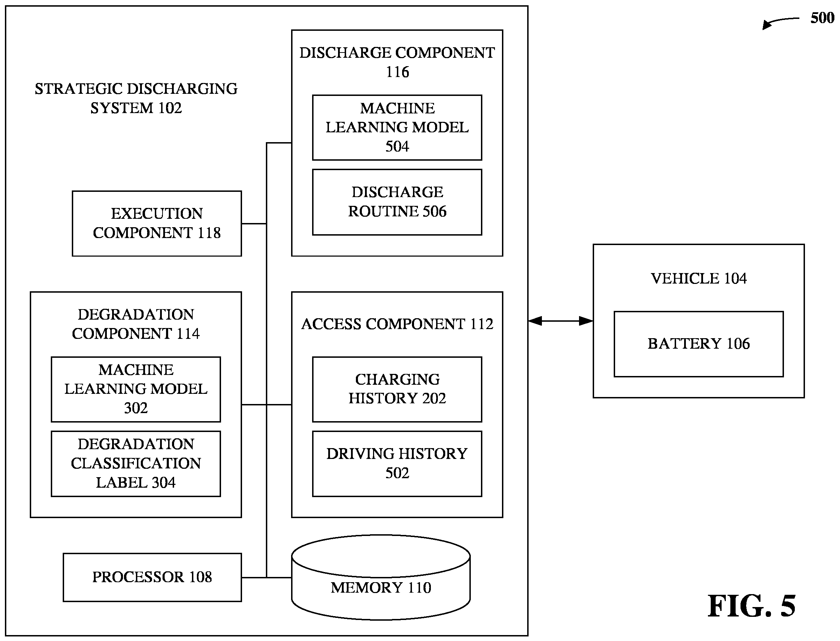

FIG. 5 illustrates a block diagram of an example, non-limiting system 500 including a driving history, a second machine learning model, and a discharge routine that can facilitate strategic discharging of vehicular batteries in accordance with one or more embodiments described herein. As shown, the system 500 can, in some cases, comprise the same components as the system 300, and can further comprise a driving history 502, a machine learning model 504, and a discharge routine 506.

In various aspects, the driving history 502 can be one or more scalars, one or more vectors, one or more matrices, one or more tensors, one or more character strings, or any suitable combination thereof that can indicate or otherwise represent how gently or how harshly the vehicle 104 was driven at, or otherwise as of, each of various past or previous times or dates. As a non-limiting example, the driving history 502 can be or comprise a timeseries showing how quickly the vehicle 104 was traveling at each of any suitable number of prior times or dates. As another non-limiting example, the driving history 502 can be or comprise a timeseries showing how quickly the vehicle 104 was accelerated or decelerated at each of any suitable number of prior times or dates. As yet another non-limiting example, the driving history 502 can be or comprise a timeseries showing how sharply or how gradually the vehicle 104 was executing a turn at each of any suitable number of prior times or dates. As even another non-limiting example, the driving history 502 can be or comprise a timeseries showing how much distance was covered by the vehicle 104 or how much time had elapsed, since a most recent recharge of the battery 106 at each of any suitable number of prior times or dates. As still another non-limiting example, the driving history 502 can be or comprise a timeseries showing which operational mode (e.g., economy mode, sport mode, offroad mode) the vehicle 104 was in at each of any suitable number of prior times/dates. In various cases, the driving history 502 can be electronically recorded, electronically tracked, or otherwise electronically generated by any suitable motion sensors of the vehicle 104 (e.g., via a speedometer of the vehicle 104, via an odometer of the vehicle 104, via an accelerometer of the vehicle 104, via a steering-degree sensor of the vehicle 104, via a gyro sensor of the vehicle 104, via a global positioning sensor of the vehicle 104).

In various embodiments, the access component 112 can electronically receive or otherwise electronically access the driving history 502. In various instances, the access component 112 can electronically retrieve the driving history 502 from any suitable centralized or decentralized data structures (not shown) or from any suitable centralized or decentralized computing devices (not shown). As a non-limiting example, the vehicle 104 can automatically generate, and continually update, the driving history 502, and the access component 112 can accordingly retrieve the driving history 502 from the vehicle 104. In any case, the access component 112 can electronically obtain or access the driving history 502, such that other components of the strategic discharging system 102 can electronically interact with the driving history 502.

In various embodiments, the discharge component 116 can electronically store, electronically maintain, electronically control, or otherwise electronically access the machine learning model 504. In various aspects, the machine learning model 504 can have or otherwise exhibit any suitable internal architecture. As a non-limiting example, the machine learning model 504 can have or otherwise exhibit a deep learning internal architecture. For instance, the machine learning model 504 can have an input layer, one or more hidden layers, and an output layer. In various instances, any of such layers can be coupled together by any suitable interneuron connections or interlayer connections, such as forward connections, skip connections, or recurrent connections. Furthermore, in various cases, any of such layers can be any suitable types of neural network layers having any suitable learnable or trainable internal parameters. For example, any of such input layer, one or more hidden layers, or output layer can be convolutional layers, whose learnable or trainable parameters can be convolutional kernels. As another example, any of such input layer, one or more hidden layers, or output layer can be dense layers, whose learnable or trainable parameters can be weight matrices or bias values. As still another example, any of such input layer, one or more hidden layers, or output layer can be batch normalization layers, whose learnable or trainable parameters can be shift factors or scale factors. Further still, in various cases, any of such layers can be any suitable types of neural network layers having any suitable fixed or non-trainable internal parameters. For example, any of such input layer, one or more hidden layers, or output layer can be non-linearity layers, padding layers, pooling layers, or concatenation layers. However, these are mere non-limiting examples. In other aspects, the machine learning model 504 can instead have any other suitable internal architecture, such as a support vector machine architecture, a naive Bayes architecture, or a random forest architecture.

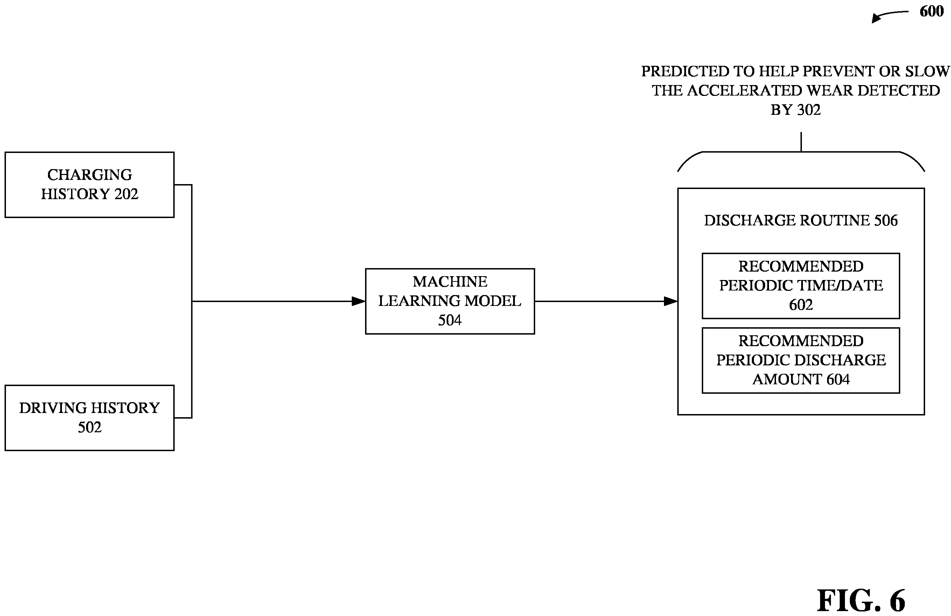

In various aspects, the discharge component 116 can electronically execute the machine learning model 504 on the charging history 202 and on the driving history 502. In various instances, such execution can cause the machine learning model 504 to produce the discharge routine 506. In various cases, the discharge routine 506 can be any suitable electronic data that indicates when and how much the battery 106 should be periodically or regularly discharged so as to slow or impede the accelerated wear indicated by the degradation classification label 304. Non-limiting aspects are described with respect to FIG. 6.

FIG. 6 illustrates an example, non-limiting block diagram 600 showing how the machine learning model 504 can generate the discharge routine 506 in accordance with one or more embodiments described herein.

In various aspects, the discharge component 116 can execute the machine learning model 504 on both the charging history 202 and the driving history 502. In various instances, such execution can cause the machine learning model 504 to produce the discharge routine 506. As a non-limiting example, the discharge component 116 can concatenate the charging history 202 and the driving history 502 together. In various cases, the discharge component 116 can feed that concatenation to an input layer of the machine learning model 504. In various instances, that concatenation can complete a forward pass through one or more hidden layers of the machine learning model 504. In various cases, an output layer of the machine learning model 504 can compute the discharge routine 506, based on activation maps or intermediate features produced by the one or more hidden layers of the machine learning model 504.

In any case, the discharge routine 506 can be one or more scalars, one or more vectors, one or more matrices, one or more tensors, one or more character strings, or any suitable combination thereof that can be considered as specifying or indicating when and how much electricity should be periodically discharged from the battery 106, so as to address or reduce the accelerated wear indicated by the degradation classification label 304. In particular, the discharge routine 506 can comprise a recommended periodic time/date 602 and a recommended periodic discharge amount 604. In various aspects, the recommended periodic time/date 602 can be any suitable time or date recited at any suitable level of granularity (e.g., year, month, week, day, hour, minute, second) that periodically or regularly repeats. As a non-limiting example, the recommended periodic time/date 602 can be every Thursday at 6:00am ET. As another non-limiting example, the recommended periodic time/date 602 can be every twelve hours starting at 7:45pm PT. In various instances, the recommended periodic discharge amount 604 can be any suitable amount of electricity, measured absolutely or relatively, that is to be discharged at the recommended periodic time/date 602. As a non-limiting example, the recommended periodic discharge amount 604 can be 25 kilowatt-hours of electricity. As another non-limiting example, the recommended periodic discharge amount 604 can be 30% of the maximum capacity of the battery 106. As even another non-limiting example, the recommended periodic discharge amount 604 can be 20% of whatever amount of electricity happens to be stored within the battery 106 at the recommended periodic time/date 602. In any case, the machine learning model 504 can have determined or inferred that the accelerated wear that was detected by the machine learning model 302 can be counteracted, nullified, blunted, softened, reduced, or otherwise slowed by discharging from the battery 106 the recommended periodic discharge amount 604 each time that the recommended periodic time/date 602 occurs.

In some aspects, the machine learning model 504 can determine the recommended periodic time/date 602 so as to be convenient for the vehicle 104. Indeed, as mentioned above, the charging history 202 can, in some instances, indicate when the vehicle 104 is usually, typically, normally, or habitually plugged into the vehicular charging station so as to undergo charging. Because the vehicular charging station can facilitate not just charging but also discharging, whatever times or dates at which the vehicle 104 is usually, typically, normally, or habitually plugged into the vehicular charging station can be considered as convenient for the performance of discharging the battery 106 (e.g., such times or dates are convenient since the vehicle 104 is expected to be already plugged into the vehicular charging station at such times or dates). Accordingly, the machine learning model 504 can select one of those times or dates as the recommended periodic time/date 602. Note that, in various cases, the recommended periodic time/date 602 can, but need not, be a time or date at which a charging session of the battery 106 normally begins. Instead, in some cases, the recommended periodic time/date 602 can be a time or date at which the battery 106 is usually, typically, normally, or habitually already in the middle of a charging session.

In some aspects, the machine learning model 504 can determine the recommended periodic discharge amount 604, so as to keep the battery 106 prepared for whatever driving usage it might encounter shortly (e.g., within any suitable threshold margin of time) after the recommended periodic time/date 602. Indeed, as mentioned above, the driving history 502 can indicate how the vehicle 104 is usually, typically, normally, or habitually driven at various times. So, the machine learning model 504 can choose or select the recommended periodic discharge amount 604, such that, after the battery 106 loses the recommended periodic discharge amount 604 at the recommended periodic time/date 602, the vehicle 104 is nevertheless able to handle whatever driving it usually, typically, normally, or habitually handles at, after, or around that time. As a non-limiting example, suppose that the driving history 502 indicates that the vehicle 104 is usually, typically, normally, or habitually driven very gently (e.g., with slow accelerations and slow, wide turns) within the hours after the recommended periodic time/date 602. In such case, the recommended periodic discharge amount 604 can have a larger magnitude, since the battery 106 can, even after losing such a large amount of electricity, still be able to handle the gentle driving that it usually, typically, normally, or habitually handles in the hours after the recommended periodic time/date 602. In other words, the battery 106 does not require very much electricity in order to handle the gentle driving that it often encounters circa the recommended periodic time/date 602, and so more electricity can be discharged at the recommended periodic time/date 602. In contrast, suppose instead that the driving history 502 indicates that the vehicle 104 is usually, typically, normally, or habitually driven very harshly (e.g., with quick, sudden accelerations and sharp, fast turns) within the hours after the recommended periodic time/date 602. In such case, the recommended periodic discharge amount 604 can have a smaller magnitude, so as to ensure that the battery 106 can, after discharging, still be able to handle the harsh driving that it usually, typically, normally, or habitually handles in the hours after the recommended periodic time/date 602. In other words, the battery 106 can require a significant amount of electricity in order to handle the harsh driving that it often encounters circa the recommended periodic time/date 602, and so less electricity can be discharged at the recommended periodic time/date 602.

Accordingly, the degradation component 114 can be considered as detecting accelerated wear caused by suboptimal charging habits of the battery 106, and the discharge component 116 can be considered as identifying a regular discharge plan that can solve or address such accelerated wear.

In various embodiments, the execution component 118 can perform any suitable electronic actions based on the discharge routine 506.

As a non-limiting example, the execution component 118 can visually render, on any suitable electronic display (e.g., on a computer screen of the vehicle 104), the discharge routine 506, such that an operator of the vehicle 104 can become aware of the discharge routine 506. In some cases, discharging electricity can be associated with a reward (e.g., a financial or monetary disbursement). So, the execution component 118 can visually render, on the electronic display, such reward in conjunction with the discharge routine 506. Thus, the operator of the vehicle 104 can become aware not just of the discharge routine 506, but also of the reward. This can help to incentivize the operator to abide by the discharge routine 506.

As another non-limiting example, suppose that the vehicle 104 is actually already plugged into the vehicular charging station when the recommended periodic time/date 602 occurs or transpires. In such case, the execution component 118 can electronically instruct or command the vehicular charging station to route away from the battery 106 the recommended periodic discharge amount 604. In other words, the execution component 118 can cause the discharge routine 506 to be performed or followed.

As even another non-limiting example, suppose that the vehicle 104 is not actually already plugged into the vehicular charging station at (or within any suitable threshold margin before) the recommended periodic time/date 602 occurs or transpires. Furthermore, suppose that the vehicle 104 is equipped or otherwise outfitted with autonomous driving or self-driving capabilities. In such case, the execution component 118 can electronically instruct or command the vehicle 104 to drive to and dock at the vehicular charging station (or whatever other vehicular charging station is within any suitable threshold distance of the vehicle 104) at the recommended periodic time/date 602. Once the vehicle 104 has self-docked at the vehicular charging station, the execution component 118 can electronically instruct or command the vehicular charging station to route away from the battery 106 the recommended periodic discharge amount 604. Again, the execution component 118 can thus be considered as causing the discharge routine 506 to be performed or followed.

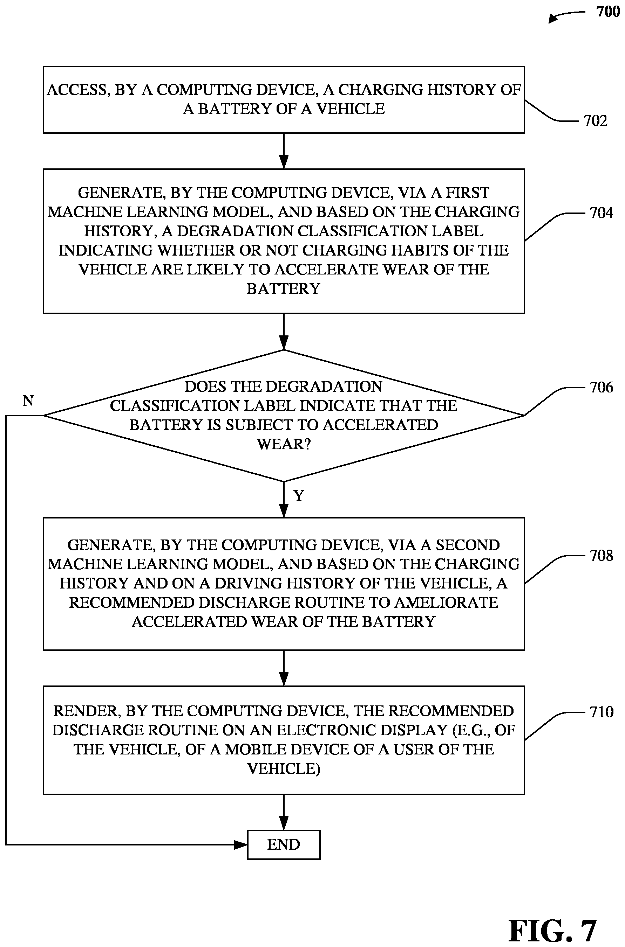

FIG. 7 illustrates a flow diagram of an example, non-limiting computer-implemented method 700 that can facilitate strategic discharging of vehicular batteries in accordance with one or more embodiments described herein. In some cases, the strategic discharge system 102 can facilitate the computer-implemented method 700.

In various embodiments, act 702 can include accessing, by a computing device (e.g., via 112), a charging history (e.g., 202) of a battery (e.g., 106) of a vehicle (e.g., 104).

In various aspects, act 704 can include generating, by the computing device (e.g., via 114), via a first machine learning model (e.g., 302), and based on the charging history, a degradation classification label (e.g., 304) indicating whether or not charging habits of the vehicle are likely to accelerate wear of the battery.

In various instances, act 706 can include determining, by the computing device (e.g., via 114), whether the degradation classification label indicates that the battery is subject to accelerated wear. If not, the computer-implemented method 700 can end. On the other hand, if so, the computer-implemented method 700 can proceed to act 708.

In various aspects, act 708 can include generating, by the computing device (e.g., via 116), via a second machine learning model (e.g., 504), and based on the charging history and on a driving history (e.g., 502) of the vehicle, a recommended discharge routine (e.g., 506) to ameliorate accelerated wear of the battery.

In various instances, act 710 can include rendering, by the computing device (e.g., via 118), the recommended discharge routine on an electronic display. In various cases, the electronic display can belong to the vehicle or can belong to a mobile device (e.g., smart phone) of a user or operator of the vehicle. In various aspects, the computer-implemented method 700 can then end.

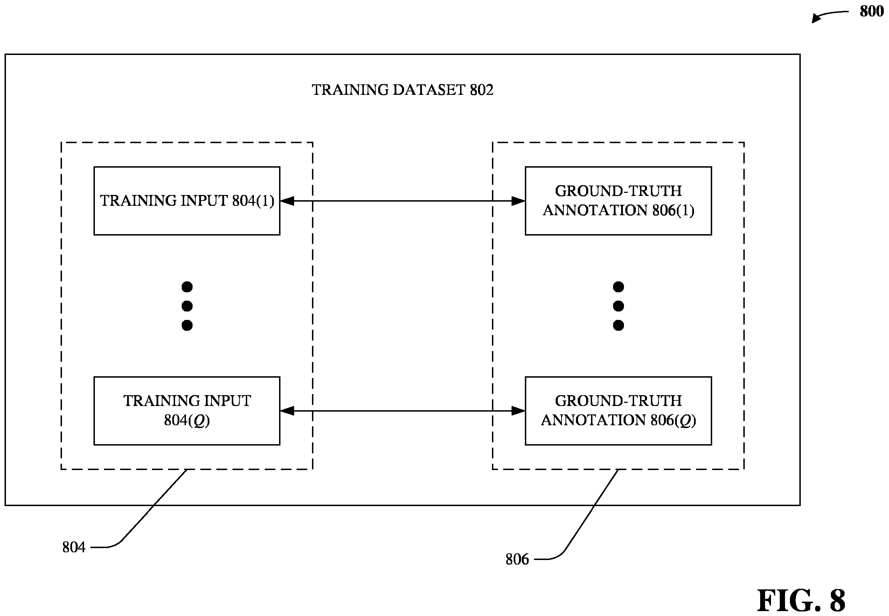

Now, in order for the degradation classification label 304 and for the discharge routine 506 to be accurate, the machine learning model 302 and the machine learning model 504 can first undergo training. As a non-limiting example, the machine learning model 302 and the machine learning model 506 can undergo supervised training, as described with respect to FIGs. 8-9.

FIG. 8 illustrates an example, non-limiting block diagram 800 of a training dataset 802 that can be used to train the machine learning model 302 or the machine learning model 504 in accordance with one or more embodiments described herein.

In various aspects, the training dataset 802 can comprise a set of training inputs 804. In various instances, the set of training inputs 804 can include q inputs for any suitable positive integer q: a training input 804(1) to a training input 804(q). In various instances, if the training dataset 802 is meant to train the machine learning model 302, then each of the set of training inputs 804 can be a training charging history having the same format, size, or dimensionality as the charging history 202. On the other hand, if the training dataset 802 is meant to train the machine learning model 504, then each of the set of training inputs 804 can be a concatenation of a training charging history having the same format, size, or dimensionality as the charging history 202 and of a training driving history having the same format, size, or dimensionality as the driving history 502.

In various aspects, the training dataset 802 can comprise a set of ground-truth annotations 806 that can respectively correspond to the set of training inputs 804. Accordingly, since the set of training inputs 804 can have q inputs, the set of ground-truth annotations 806 can have q annotations: a ground-truth annotation 806(1) to a ground-truth annotation 806(q). In various instances, if the training dataset 802 is meant to train the machine learning model 302, then each of the set of ground-truth annotations 806 can be a correct or accurate degradation classification label (having the same format, size, or dimensionality as the degradation classification label 304) that is known or deemed to correspond to a respective one of the set of training inputs 804. On the other hand, if the training dataset 802 is meant to train the machine learning model 504, then each of the set of ground-truth annotations 806 can be a correct or accurate discharge routine (having the same format, size, or dimensionality as the discharge routine 506) that is known or deemed to correspond to a respective one of the set of training inputs 804.

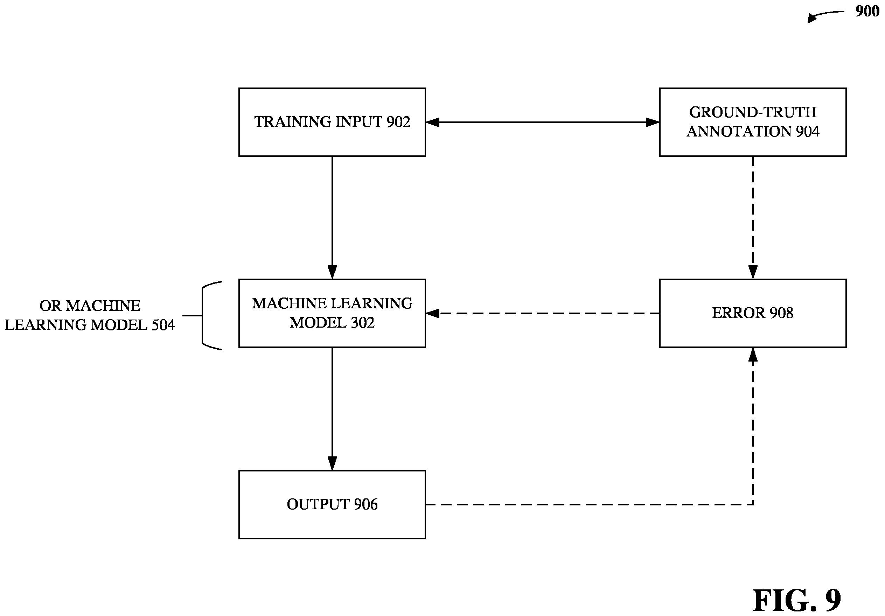

FIG. 9 illustrates an example, non-limiting block diagram 900 showing how the machine learning model 302 or the machine learning model 504 can be trained in accordance with one or more embodiments described herein.

In various aspects, prior to beginning training, trainable internal parameters (e.g., convolutional kernels, weight matrices, bias values) of the machine learning model 302 (or of the machine learning model 504) can be initialized in any suitable fashion (e.g., via random initialization).

In various aspects, a training input 902 and a ground-truth annotation 904 corresponding to the training input 902 can be selected from the training dataset 802. In various instances, the machine learning model 302 (or the machine learning model 504) can be executed on the training input 902, thereby causing the machine learning model 302 (or the machine learning model 504) to produce an output 906. More specifically, in some cases, an input layer of the machine learning model 302 (or the machine learning model 504) can receive the training input 902, the training input 902 can complete a forward pass through one or more hidden layers of the machine learning model 302 (or the machine learning model 504), and an output layer of the machine learning model 302 (or the machine learning model 504) can compute the output 906 based on activation maps or intermediate features provided by the one or more hidden layers of the machine learning model 302 (or the machine learning model 504).

Note that the format, size, or dimensionality of the output 906 can be dictated by the number, arrangement, sizes, or other characteristics of the neurons, convolutional kernels, or other internal parameters of the output layer (or of any other layers) of the machine learning model 302 (or of the machine learning model 504). Accordingly, the output 906 can be forced to have any desired format, size, or dimensionality, by adding, removing, or otherwise adjusting characteristics of the output layer (or of any other layers) of the machine learning model 302 (or of the machine learning model 504).

In various aspects, if the output 906 is produced by the machine learning model 302, the output 906 can be considered as the predicted or inferred degradation classification label that the machine learning model 302 believes should correspond to the training input 902. On the other hand, if the output 906 is produced by the machine learning model 504, the output 906 can be considered as the predicted or inferred discharge routine that the machine learning model 504 believes should correspond to the training input 902. In any case, the ground-truth annotation 904 can be considered as whatever correct or accurate result (e.g., correct or accurate degradation classification label, correct or accurate discharge routine) that is known or deemed to correspond to the training input 902. Note that, if the machine learning model 302 (or the machine learning model 504) has so far undergone no or little training, then the output 906 can be highly inaccurate. In other words, the output 906 can be very different from the ground-truth annotation 904.

In various aspects, an error 908 (e.g., mean absolute error, mean squared error, cross-entropy error) between the output 906 and the ground-truth annotation 904 can be computed. In various instances, the trainable internal parameters of the machine learning model 302 (or the machine learning model 504) can be incrementally updated, via backpropagation (e.g., stochastic gradient descent), based on the error 908.

In various cases, such execution-and-update procedure can be repeated for any suitable number of training inputs (e.g., for each training input in the training dataset 802). This can ultimately cause the trainable internal parameters of the machine learning model 302 (or the machine learning model 504) to become iteratively optimized for accurately generating degradation classification labels (or discharge routines). In various aspects, any suitable training batch sizes, any suitable error/loss functions, or any suitable training termination criteria can be implemented.

Although the above description mainly describes the machine learning model 302 and the machine learning model 504 as being trained in supervised fashion, this is a mere non-limiting example for ease of illustration and explanation. In various cases, any other suitable training paradigms (e.g., unsupervised training, reinforcement learning) can be implemented to train the machine learning model 302 or the machine learning model 504.

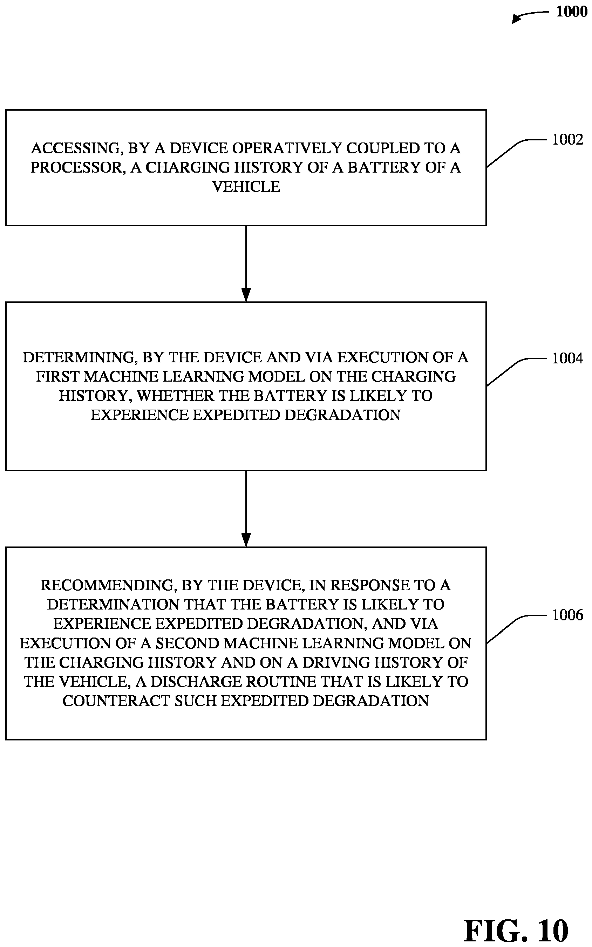

FIG. 10 illustrates a flow diagram of an example, non-limiting computer-implemented method 1000 that can facilitate strategic discharging of vehicular batteries in accordance with one or more embodiments described herein. In various cases, the strategic discharge system 102 can facilitate the computer-implemented method 1000.

In various embodiments, act 1002 can include accessing, by a device (e.g., via 112) operatively coupled to a processor (e.g., 108), a charging history (e.g., 202) of a battery (e.g., 106) of a vehicle (e.g., 104).

In various aspects, act 1004 can include determining, by the device (e.g., via 114) and via execution of a first machine learning model (e.g., 302) on the charging history, whether the battery is likely to experience expedited degradation (e.g., indicated by 304).

In various instances, act 1006 can include recommending, by the device (e.g., via 116), in response to a determination that the battery is likely to experience expedited degradation, and via execution of a second machine learning model (e.g., 504) on the charging history and on a driving history (e.g., 502) of the vehicle, a discharge routine (e.g., 506) that is likely to counteract such expedited degradation.

Although not explicitly shown in FIG. 10, the discharge routine can comprise a recommended time or date (e.g., 602) determined by the second machine learning model to be suitable for periodic discharging of the battery, and the discharge routine can further comprise a recommended discharge amount (e.g., 604) to be periodically discharged at the recommended time or date.

Although not explicitly shown in FIG. 10, the computer-implemented method 1000 can comprise: visually rendering, by the device (e.g., via 118), the discharge routine on an electronic display. In various instances, the computer-implemented method 1000 can comprise: visually rendering, by the device (e.g., via 118) and on the electronic display, a reward associated with the discharge routine.

Although not explicitly shown in FIG. 10, the vehicle can be docked at a vehicular charging station, and the computer-implemented method 1000 can comprise: causing, by the device (e.g., via 118), the battery to discharge the recommended discharge amount to the vehicular charging station at the recommended time or date.

Although not explicitly shown in FIG. 10, the vehicle can be equipped with autonomous driving controls, and the computer-implemented method 1000 can comprise: causing, by the device (e.g., via 118) and via the autonomous driving controls, the vehicle to travel to and dock at the vehicular charging station prior to the recommended time or date.

In various instances, machine learning algorithms or models can be implemented in any suitable way to facilitate any suitable aspects described herein. To facilitate some of the above-described machine learning aspects of various embodiments, consider the following discussion of artificial intelligence (AI). Various embodiments described herein can employ artificial intelligence to facilitate automating one or more features or functionalities. The components can employ various AI-based schemes for carrying out various embodiments/examples disclosed herein. In order to provide for or aid in the numerous determinations (e.g., determine, ascertain, infer, calculate, predict, prognose, estimate, derive, forecast, detect, compute) described herein, components described herein can examine the entirety or a subset of the data to which it is granted access and can provide for reasoning about or determine states of the system or environment from a set of observations as captured via events or data. Determinations can be employed to identify a specific context or action, or can generate a probability distribution over states, for example. The determinations can be probabilistic; that is, the computation of a probability distribution over states of interest based on a consideration of data and events. Determinations can also refer to techniques employed for composing higher-level events from a set of events or data.

Such determinations can result in the construction of new events or actions from a set of observed events or stored event data, whether or not the events are correlated in close temporal proximity, and whether the events and data come from one or several event and data sources. Components disclosed herein can employ various classification (explicitly trained (e.g., via training data) as well as implicitly trained (e.g., via observing behavior, preferences, historical information, receiving extrinsic information, and so on)) schemes or systems (e.g., support vector machines, neural networks, expert systems, Bayesian belief networks, fuzzy logic, data fusion engines, and so on) in connection with performing automatic or determined action in connection with the claimed subject matter. Thus, classification schemes or systems can be used to automatically learn and perform a number of functions, actions, or determinations.

A classifier can map an input attribute vector, z = (z₁, z₂, z₃, z₄, *zₙ*), to a confidence that the input belongs to a class, as by f(z) = *confidence*(*class*)*.* Such classification can employ a probabilistic or statistical-based analysis (e.g., factoring into the analysis utilities and costs) to determinate an action to be automatically performed. A support vector machine (SVM) can be an example of a classifier that can be employed. The SVM operates by finding a hyper-surface in the space of possible inputs, where the hyper-surface attempts to split the triggering criteria from the non-triggering events. Intuitively, this makes the classification correct for testing data that is near, but not identical to training data. Other directed and undirected model classification approaches include, e.g., naive Bayes, Bayesian networks, decision trees, neural networks, fuzzy logic models, or probabilistic classification models providing different patterns of independence, any of which can be employed. Classification as used herein also is inclusive of statistical regression that is utilized to develop models of priority.

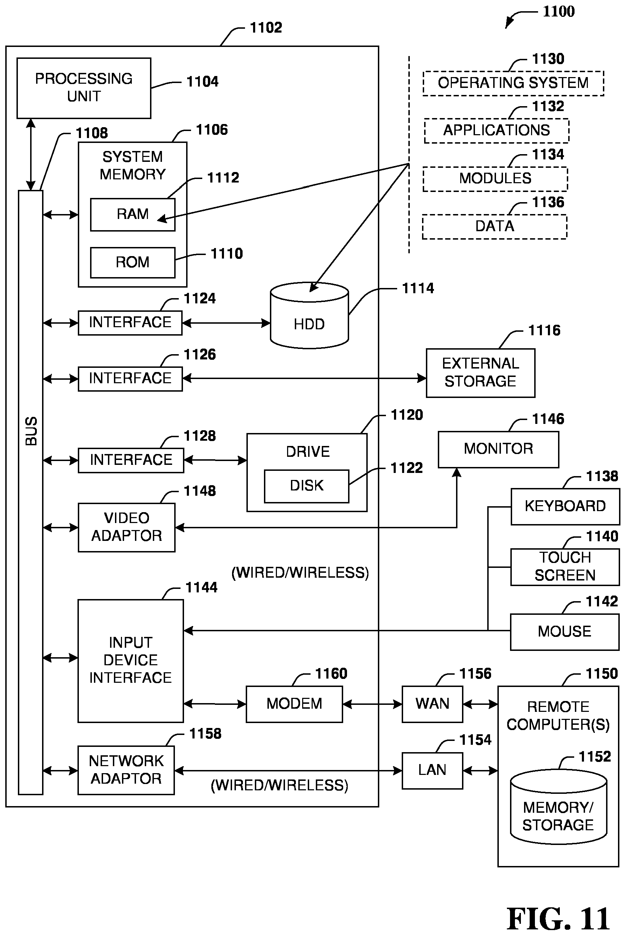

In order to provide additional context for various embodiments described herein, FIG. 11 and the following discussion are intended to provide a brief, general description of a suitable computing environment 1100 in which the various embodiments of the embodiment described herein can be implemented. While the embodiments have been described above in the general context of computer-executable instructions that can run on one or more computers, those skilled in the art will recognize that the embodiments can be also implemented in combination with other program modules or as a combination of hardware and software.

Generally, program modules include routines, programs, components, data structures, etc., that perform particular tasks or implement particular abstract data types. Moreover, those skilled in the art will appreciate that the inventive methods can be practiced with other computer system configurations, including single-processor or multi-processor computer systems, minicomputers, mainframe computers, Internet of Things (IoT) devices, distributed computing systems, as well as personal computers, hand-held computing devices, microprocessor-based or programmable consumer electronics, and the like, each of which can be operatively coupled to one or more associated devices.

The illustrated embodiments of the embodiments herein can be also practiced in distributed computing environments where certain tasks are performed by remote processing devices that are linked through a communications network. In a distributed computing environment, program modules can be located in both local and remote memory storage devices.

Computing devices typically include a variety of media, which can include computer-readable storage media, machine-readable storage media, or communications media, which two terms are used herein differently from one another as follows. Computer-readable storage media or machine-readable storage media can be any available storage media that can be accessed by the computer and includes both volatile and nonvolatile media, removable and non-removable media. By way of example, and not limitation, computer-readable storage media or machine-readable storage media can be implemented in connection with any method or technology for storage of information such as computer-readable or machine-readable instructions, program modules, structured data or unstructured data.

Computer-readable storage media can include, but are not limited to, random access memory (RAM), read only memory (ROM), electrically erasable programmable read only memory (EEPROM), flash memory or other memory technology, compact disk read only memory (CD-ROM), digital versatile disk (DVD), Blu-ray disc (BD) or other optical disk storage, magnetic cassettes, magnetic tape, magnetic disk storage or other magnetic storage devices, solid state drives or other solid state storage devices, or other tangible or non-transitory media which can be used to store desired information. In this regard, the terms "tangible" or "non-transitory" herein as applied to storage, memory or computer-readable media, are to be understood to exclude only propagating transitory signals per se as modifiers and do not relinquish rights to all standard storage, memory or computer-readable media that are not only propagating transitory signals per se.

Computer-readable storage media can be accessed by one or more local or remote computing devices, e.g., via access requests, queries or other data retrieval protocols, for a variety of operations with respect to the information stored by the medium.

Communications media typically embody computer-readable instructions, data structures, program modules or other structured or unstructured data in a data signal such as a modulated data signal, e.g., a carrier wave or other transport mechanism, and includes any information delivery or transport media. The term "modulated data signal" or signals refers to a signal that has one or more of its characteristics set or changed in such a manner as to encode information in one or more signals. By way of example, and not limitation, communication media include wired media, such as a wired network or direct-wired connection, and wireless media such as acoustic, RF, infrared and other wireless media.

With reference again to FIG. 11, the example environment 1100 for implementing various embodiments of the aspects described herein includes a computer 1102, the computer 1102 including a processing unit 1104, a system memory 1106 and a system bus 1108. The system bus 1108 couples system components including, but not limited to, the system memory 1106 to the processing unit 1104. The processing unit 1104 can be any of various commercially available processors. Dual microprocessors and other multi-processor architectures can also be employed as the processing unit 1104.

The system bus 1108 can be any of several types of bus structure that can further interconnect to a memory bus (with or without a memory controller), a peripheral bus, and a local bus using any of a variety of commercially available bus architectures. The system memory 1106 includes ROM 1110 and RAM 1112. A basic input/output system (BIOS) can be stored in a non-volatile memory such as ROM, erasable programmable read only memory (EPROM), EEPROM, which BIOS contains the basic routines that help to transfer information between elements within the computer 1102, such as during startup. The RAM 1112 can also include a high-speed RAM such as static RAM for caching data.

The computer 1102 further includes an internal hard disk drive (HDD) 1114 (e.g., EIDE, SATA), one or more external storage devices 1116 (e.g., a magnetic floppy disk drive (FDD) 1116, a memory stick or flash drive reader, a memory card reader, etc.) and a drive 1120, e.g., such as a solid state drive, an optical disk drive, which can read or write from a disk 1122, such as a CD-ROM disc, a DVD, a BD, etc. Alternatively, where a solid state drive is involved, disk 1122 would not be included, unless separate. While the internal HDD 1114 is illustrated as located within the computer 1102, the internal HDD 1114 can also be configured for external use in a suitable chassis (not shown). Additionally, while not shown in environment 1100, a solid state drive (SSD) could be used in addition to, or in place of, an HDD 1114. The HDD 1114, external storage device(s) 1116 and drive 1120 can be connected to the system bus 1108 by an HDD interface 1124, an external storage interface 1126 and a drive interface 1128, respectively. The interface 1124 for external drive implementations can include at least one or both of Universal Serial Bus (USB) and Institute of Electrical and Electronics Engineers (IEEE) 1394 interface technologies. Other external drive connection technologies are within contemplation of the embodiments described herein.

The drives and their associated computer-readable storage media provide nonvolatile storage of data, data structures, computer-executable instructions, and so forth. For the computer 1102, the drives and storage media accommodate the storage of any data in a suitable digital format. Although the description of computer-readable storage media above refers to respective types of storage devices, it should be appreciated by those skilled in the art that other types of storage media which are readable by a computer, whether presently existing or developed in the future, could also be used in the example operating environment, and further, that any such storage media can contain computer-executable instructions for performing the methods described herein.

A number of program modules can be stored in the drives and RAM 1112, including an operating system 1130, one or more application programs 1132, other program modules 1134 and program data 1136. All or portions of the operating system, applications, modules, or data can also be cached in the RAM 1112. The systems and methods described herein can be implemented utilizing various commercially available operating systems or combinations of operating systems.

Computer 1102 can optionally comprise emulation technologies. For example, a hypervisor (not shown) or other intermediary can emulate a hardware environment for operating system 1130, and the emulated hardware can optionally be different from the hardware illustrated in FIG. 11. In such an embodiment, operating system 1130 can comprise one virtual machine (VM) of multiple VMs hosted at computer 1102. Furthermore, operating system 1130 can provide runtime environments, such as the Java runtime environment or the .NET framework, for applications 1132. Runtime environments are consistent execution environments that allow applications 1132 to run on any operating system that includes the runtime environment. Similarly, operating system 1130 can support containers, and applications 1132 can be in the form of containers, which are lightweight, standalone, executable packages of software that include, e.g., code, runtime, system tools, system libraries and settings for an application.

Further, computer 1102 can be enable with a security module, such as a trusted processing module (TPM). For instance with a TPM, boot components hash next in time boot components, and wait for a match of results to secured values, before loading a next boot component. This process can take place at any layer in the code execution stack of computer 1102, e.g., applied at the application execution level or at the operating system (OS) kernel level, thereby enabling security at any level of code execution.

A user can enter commands and information into the computer 1102 through one or more wired/wireless input devices, e.g., a keyboard 1138, a touch screen 1140, and a pointing device, such as a mouse 1142. Other input devices (not shown) can include a microphone, an infrared (IR) remote control, a radio frequency (RF) remote control, or other remote control, a joystick, a virtual reality controller or virtual reality headset, a game pad, a stylus pen, an image input device, e.g., camera(s), a gesture sensor input device, a vision movement sensor input device, an emotion or facial detection device, a biometric input device, e.g., fingerprint or iris scanner, or the like. These and other input devices are often connected to the processing unit 1104 through an input device interface 1144 that can be coupled to the system bus 1108, but can be connected by other interfaces, such as a parallel port, an IEEE 1394 serial port, a game port, a USB port, an IR interface, a BLUETOOTH^{®} interface, etc.

A monitor 1146 or other type of display device can be also connected to the system bus 1108 via an interface, such as a video adapter 1148. In addition to the monitor 1146, a computer typically includes other peripheral output devices (not shown), such as speakers, printers, etc.

The computer 1102 can operate in a networked environment using logical connections via wired or wireless communications to one or more remote computers, such as a remote computer(s) 1150. The remote computer(s) 1150 can be a workstation, a server computer, a router, a personal computer, portable computer, microprocessor-based entertainment appliance, a peer device or other common network node, and typically includes many or all of the elements described relative to the computer 1102, although, for purposes of brevity, only a memory/storage device 1152 is illustrated. The logical connections depicted include wired/wireless connectivity to a local area network (LAN) 1154 or larger networks, e.g., a wide area network (WAN) 1156. Such LAN and WAN networking environments are commonplace in offices and companies, and facilitate enterprise-wide computer networks, such as intranets, all of which can connect to a global communications network, e.g., the Internet.

When used in a LAN networking environment, the computer 1102 can be connected to the local network 1154 through a wired or wireless communication network interface or adapter 1158. The adapter 1158 can facilitate wired or wireless communication to the LAN 1154, which can also include a wireless access point (AP) disposed thereon for communicating with the adapter 1158 in a wireless mode.

When used in a WAN networking environment, the computer 1102 can include a modem 1160 or can be connected to a communications server on the WAN 1156 via other means for establishing communications over the WAN 1156, such as by way of the Internet. The modem 1160, which can be internal or external and a wired or wireless device, can be connected to the system bus 1108 via the input device interface 1144. In a networked environment, program modules depicted relative to the computer 1102 or portions thereof, can be stored in the remote memory/storage device 1152. It will be appreciated that the network connections shown are example and other means of establishing a communications link between the computers can be used.

When used in either a LAN or WAN networking environment, the computer 1102 can access cloud storage systems or other network-based storage systems in addition to, or in place of, external storage devices 1116 as described above, such as but not limited to a network virtual machine providing one or more aspects of storage or processing of information. Generally, a connection between the computer 1102 and a cloud storage system can be established over a LAN 1154 or WAN 1156 e.g., by the adapter 1158 or modem 1160, respectively. Upon connecting the computer 1102 to an associated cloud storage system, the external storage interface 1126 can, with the aid of the adapter 1158 or modem 1160, manage storage provided by the cloud storage system as it would other types of external storage. For instance, the external storage interface 1126 can be configured to provide access to cloud storage sources as if those sources were physically connected to the computer 1102.

The computer 1102 can be operable to communicate with any wireless devices or entities operatively disposed in wireless communication, e.g., a printer, scanner, desktop or portable computer, portable data assistant, communications satellite, any piece of equipment or location associated with a wirelessly detectable tag (e.g., a kiosk, news stand, store shelf, etc.), and telephone. This can include Wireless Fidelity (Wi-Fi) and BLUETOOTH^{®} wireless technologies. Thus, the communication can be a predefined structure as with a conventional network or simply an ad hoc communication between at least two devices.

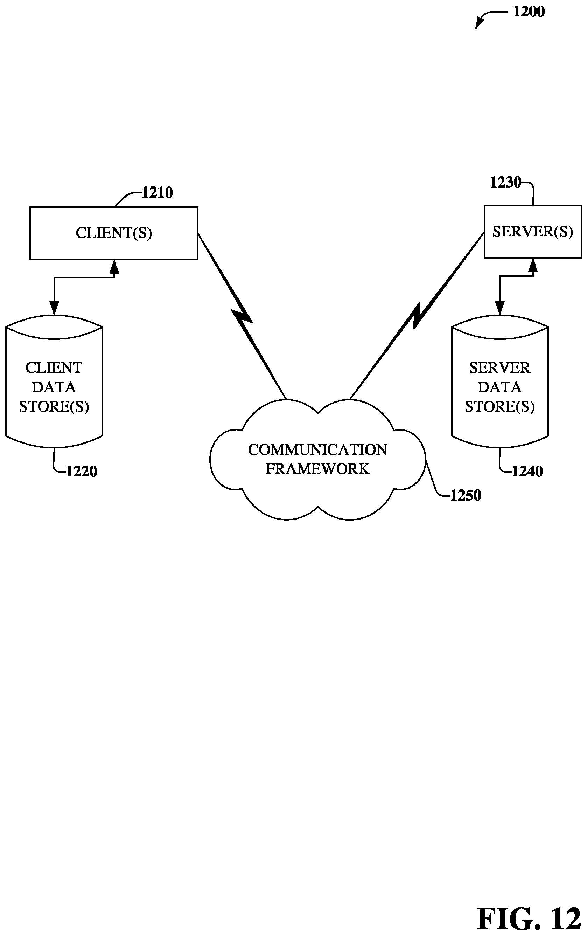

FIG. 12 is a schematic block diagram of a sample computing environment 1200 with which the disclosed subject matter can interact. The sample computing environment 1200 includes one or more client(s) 1210. The client(s) 1210 can be hardware or software (e.g., threads, processes, computing devices). The sample computing environment 1200 also includes one or more server(s) 1230. The server(s) 1230 can also be hardware or software (e.g., threads, processes, computing devices). The servers 1230 can house threads to perform transformations by employing one or more embodiments as described herein, for example. One possible communication between a client 1210 and a server 1230 can be in the form of a data packet adapted to be transmitted between two or more computer processes. The sample computing environment 1200 includes a communication framework 1250 that can be employed to facilitate communications between the client(s) 1210 and the server(s) 1230. The client(s) 1210 are operably connected to one or more client data store(s) 1220 that can be employed to store information local to the client(s) 1210. Similarly, the server(s) 1230 are operably connected to one or more server data store(s) 1240 that can be employed to store information local to the servers 1230.

Various embodiments may be a system, a method, an apparatus or a computer program product at any possible technical detail level of integration. The computer program product can include a computer readable storage medium (or media) having computer readable program instructions thereon for causing a processor to carry out aspects of various embodiments. The computer readable storage medium can be a tangible device that can retain and store instructions for use by an instruction execution device. The computer readable storage medium can be, for example, but is not limited to, an electronic storage device, a magnetic storage device, an optical storage device, an electromagnetic storage device, a semiconductor storage device, or any suitable combination of the foregoing. A non-exhaustive list of more specific examples of the computer readable storage medium can also include the following: a portable computer diskette, a hard disk, a random access memory (RAM), a read-only memory (ROM), an erasable programmable read-only memory (EPROM or Flash memory), a static random access memory (SRAM), a portable compact disc read-only memory (CD-ROM), a digital versatile disk (DVD), a memory stick, a floppy disk, a mechanically encoded device such as punch-cards or raised structures in a groove having instructions recorded thereon, and any suitable combination of the foregoing. A computer readable storage medium, as used herein, is not to be construed as being transitory signals per se, such as radio waves or other freely propagating electromagnetic waves, electromagnetic waves propagating through a waveguide or other transmission media (e.g., light pulses passing through a fiber-optic cable), or electrical signals transmitted through a wire.

Computer readable program instructions described herein can be downloaded to respective computing/processing devices from a computer readable storage medium or to an external computer or external storage device via a network, for example, the Internet, a local area network, a wide area network or a wireless network. The network can comprise copper transmission cables, optical transmission fibers, wireless transmission, routers, firewalls, switches, gateway computers or edge servers. A network adapter card or network interface in each computing/processing device receives computer readable program instructions from the network and forwards the computer readable program instructions for storage in a computer readable storage medium within the respective computing/processing device. Computer readable program instructions for carrying out operations of various embodiments can be assembler instructions, instruction-set-architecture (ISA) instructions, machine instructions, machine dependent instructions, microcode, firmware instructions, state-setting data, configuration data for integrated circuitry, or either source code or object code written in any combination of one or more programming languages, including an object oriented programming language such as Smalltalk, C++, or the like, and procedural programming languages, such as the "C" programming language or similar programming languages. The computer readable program instructions can execute entirely on the user's computer, partly on the user's computer, as a stand-alone software package, partly on the user's computer and partly on a remote computer or entirely on the remote computer or server. In the latter scenario, the remote computer can be connected to the user's computer through any type of network, including a local area network (LAN) or a wide area network (WAN), or the connection can be made to an external computer (for example, through the Internet using an Internet Service Provider). In some embodiments, electronic circuitry including, for example, programmable logic circuitry, field-programmable gate arrays (FPGA), or programmable logic arrays (PLA) can execute the computer readable program instructions by utilizing state information of the computer readable program instructions to personalize the electronic circuitry, in order to perform various aspects.

Various aspects are described herein with reference to flowchart illustrations or block diagrams of methods, apparatus (systems), and computer program products according to various embodiments. It will be understood that each block of the flowchart illustrations or block diagrams, and combinations of blocks in the flowchart illustrations or block diagrams, can be implemented by computer readable program instructions. These computer readable program instructions can be provided to a processor of a general purpose computer, special purpose computer, or other programmable data processing apparatus to produce a machine, such that the instructions, which execute via the processor of the computer or other programmable data processing apparatus, create means for implementing the functions/acts specified in the flowchart or block diagram block or blocks. These computer readable program instructions can also be stored in a computer readable storage medium that can direct a computer, a programmable data processing apparatus, or other devices to function in a particular manner, such that the computer readable storage medium having instructions stored therein comprises an article of manufacture including instructions which implement aspects of the function/act specified in the flowchart or block diagram block or blocks. The computer readable program instructions can also be loaded onto a computer, other programmable data processing apparatus, or other device to cause a series of operational acts to be performed on the computer, other programmable apparatus or other device to produce a computer implemented process, such that the instructions which execute on the computer, other programmable apparatus, or other device implement the functions/acts specified in the flowchart or block diagram block or blocks.

The flowcharts and block diagrams in the Figures illustrate the architecture, functionality, and operation of possible implementations of systems, methods, and computer program products according to various embodiments. In this regard, each block in the flowchart or block diagrams can represent a module, segment, or portion of instructions, which comprises one or more executable instructions for implementing the specified logical function(s). In some alternative implementations, the functions noted in the blocks can occur out of the order noted in the Figures. For example, two blocks shown in succession can, in fact, be executed substantially concurrently, or the blocks can sometimes be executed in the reverse order, depending upon the functionality involved. It will also be noted that each block of the block diagrams or flowchart illustration, and combinations of blocks in the block diagrams or flowchart illustration, can be implemented by special purpose hardware-based systems that perform the specified functions or acts or carry out combinations of special purpose hardware and computer instructions.

While the subject matter has been described above in the general context of computer-executable instructions of a computer program product that runs on a computer or computers, those skilled in the art will recognize that this disclosure also can or can be implemented in combination with other program modules. Generally, program modules include routines, programs, components, data structures, etc. that perform particular tasks or implement particular abstract data types. Moreover, those skilled in the art will appreciate that various aspects can be practiced with other computer system configurations, including single-processor or multiprocessor computer systems, mini-computing devices, mainframe computers, as well as computers, hand-held computing devices (e.g., PDA, phone), microprocessor-based or programmable consumer or industrial electronics, and the like. The illustrated aspects can also be practiced in distributed computing environments in which tasks are performed by remote processing devices that are linked through a communications network. However, some, if not all aspects of this disclosure can be practiced on stand-alone computers. In a distributed computing environment, program modules can be located in both local and remote memory storage devices.

As used in this application, the terms "component," "system," "platform," "interface," and the like, can refer to or can include a computer-related entity or an entity related to an operational machine with one or more specific functionalities. The entities disclosed herein can be either hardware, a combination of hardware and software, software, or software in execution. For example, a component can be, but is not limited to being, a process running on a processor, a processor, an object, an executable, a thread of execution, a program, or a computer. By way of illustration, both an application running on a server and the server can be a component. One or more components can reside within a process or thread of execution and a component can be localized on one computer or distributed between two or more computers. In another example, respective components can execute from various computer readable media having various data structures stored thereon. The components can communicate via local or remote processes such as in accordance with a signal having one or more data packets (e.g., data from one component interacting with another component in a local system, distributed system, or across a network such as the Internet with other systems via the signal). As another example, a component can be an apparatus with specific functionality provided by mechanical parts operated by electric or electronic circuitry, which is operated by a software or firmware application executed by a processor. In such a case, the processor can be internal or external to the apparatus and can execute at least a part of the software or firmware application. As yet another example, a component can be an apparatus that provides specific functionality through electronic components without mechanical parts, wherein the electronic components can include a processor or other means to execute software or firmware that confers at least in part the functionality of the electronic components. In an aspect, a component can emulate an electronic component via a virtual machine, e.g., within a cloud computing system.

In addition, the term "or" is intended to mean an inclusive "or" rather than an exclusive "or." That is, unless specified otherwise, or clear from context, "X employs A or B" is intended to mean any of the natural inclusive permutations. That is, if X employs A; X employs B; or X employs both A and B, then "X employs A or B" is satisfied under any of the foregoing instances. As used herein, the term "and/or" is intended to have the same meaning as "or." Moreover, articles "a" and "an" as used in the subject specification and annexed drawings should generally be construed to mean "one or more" unless specified otherwise or clear from context to be directed to a singular form. As used herein, the terms "example" or "exemplary" are utilized to mean serving as an example, instance, or illustration. For the avoidance of doubt, the subject matter disclosed herein is not limited by such examples. In addition, any aspect or design described herein as an "example" or "exemplary" is not necessarily to be construed as preferred or advantageous over other aspects or designs, nor is it meant to preclude equivalent exemplary structures and techniques known to those of ordinary skill in the art.

The herein disclosure describes non-limiting examples. For ease of description or explanation, various portions of the herein disclosure utilize the term "each," "every," or "all" when discussing various examples. Such usages of the term "each," "every," or "all" are non-limiting. In other words, when the herein disclosure provides a description that is applied to "each," "every," or "all" of some particular object or component, it should be understood that this is a non-limiting example, and it should be further understood that, in various other examples, it can be the case that such description applies to fewer than "each," "every," or "all" of that particular object or component.

As it is employed in the subject specification, the term "processor" can refer to substantially any computing processing unit or device comprising, but not limited to, single-core processors; single-processors with software multithread execution capability; multi-core processors; multi-core processors with software multithread execution capability; multi-core processors with hardware multithread technology; parallel platforms; and parallel platforms with distributed shared memory. Additionally, a processor can refer to an integrated circuit, an application specific integrated circuit (ASIC), a digital signal processor (DSP), a field programmable gate array (FPGA), a programmable logic controller (PLC), a complex programmable logic device (CPLD), a discrete gate or transistor logic, discrete hardware components, or any combination thereof designed to perform the functions described herein. Further, processors can exploit nano-scale architectures such as, but not limited to, molecular and quantum-dot based transistors, switches and gates, in order to optimize space usage or enhance performance of user equipment. A processor can also be implemented as a combination of computing processing units. In this disclosure, terms such as "store," "storage," "data store," data storage," "database," and substantially any other information storage component relevant to operation and functionality of a component are utilized to refer to "memory components," entities embodied in a "memory," or components comprising a memory. It is to be appreciated that memory or memory components described herein can be either volatile memory or nonvolatile memory, or can include both volatile and nonvolatile memory. By way of illustration, and not limitation, nonvolatile memory can include read only memory (ROM), programmable ROM (PROM), electrically programmable ROM (EPROM), electrically erasable ROM (EEPROM), flash memory, or nonvolatile random access memory (RAM) (e.g., ferroelectric RAM (FeRAM). Volatile memory can include RAM, which can act as external cache memory, for example. By way of illustration and not limitation, RAM is available in many forms such as synchronous RAM (SRAM), dynamic RAM (DRAM), synchronous DRAM (SDRAM), double data rate SDRAM (DDR SDRAM), enhanced SDRAM (ESDRAM), Synchlink DRAM (SLDRAM), direct Rambus RAM (DRRAM), direct Rambus dynamic RAM (DRDRAM), and Rambus dynamic RAM (RDRAM). Additionally, the disclosed memory components of systems or computer-implemented methods herein are intended to include, without being limited to including, these and any other suitable types of memory.

What has been described above include mere examples of systems and computer-implemented methods. It is, of course, not possible to describe every conceivable combination of components or computer-implemented methods for purposes of describing this disclosure, but many further combinations and permutations of this disclosure are possible. Furthermore, to the extent that the terms "includes," "has," "possesses," and the like are used in the detailed description, claims, appendices and drawings such terms are intended to be inclusive in a manner similar to the term "comprising" as "comprising" is interpreted when employed as a transitional word in a claim.

The descriptions of the various embodiments have been presented for purposes of illustration, but are not intended to be exhaustive or limited to the embodiments disclosed. Many modifications and variations will be apparent without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

Various non-limiting aspects of various embodiments described herein are presented in the following clauses.

CLAUSE 1: A system, comprising: a processor that executes computer-executable components stored in a non-transitory computer-readable memory, the computer-executable components comprising: an access component that accesses a charging history of a battery of a vehicle; and a degradation component that determines, via execution of a first machine learning model on the charging history, whether the battery is likely to experience expedited degradation.

CLAUSE 2: The system of any preceding clause, wherein the computer-executable components further comprise: a discharge component that recommends, in response to a determination that the battery is likely to experience expedited degradation and via execution of a second machine learning model on the charging history and on a driving history of the vehicle, a discharge routine that is likely to counteract such expedited degradation.

CLAUSE 3: The system of any preceding clause, wherein the discharge routine comprises a recommended time or date determined by the second machine learning model to be suitable for periodic discharging of the battery, and wherein the discharge routine further comprises a recommended discharge amount to be periodically discharged at the recommended time or date.

CLAUSE 4: The system of any preceding clause, wherein the discharge component visually renders the discharge routine on an electronic display.

CLAUSE 5: The system of any preceding clause, wherein the discharge component visually renders on the electronic display a reward associated with the discharge routine.

CLAUSE 6: The system of any preceding clause, wherein the vehicle is docked at a vehicular charging station, and wherein the computer-executable components further comprise: an execution component that causes the battery to discharge the recommended discharge amount to the vehicular charging station at the recommended time or date.

CLAUSE 7: The system of any preceding clause, wherein the vehicle is equipped with autonomous driving controls, and wherein the execution component causes, via the autonomous driving controls, the vehicle to travel to and dock at the vehicular charging station prior to the recommended time or date.

In various cases, any suitable combination or combinations of clauses 1 to 7 can be implemented.

CLAUSE 8: A computer-implemented method, comprising: accessing, by a device operatively coupled to a processor, a charging history of a battery of a vehicle; and determining, by the device and via execution of a first machine learning model on the charging history, whether the battery is likely to experience expedited degradation.

CLAUSE 9: The computer-implemented method of any preceding clause, further comprising: recommending, by the device, in response to a determination that the battery is likely to experience expedited degradation, and via execution of a second machine learning model on the charging history and on a driving history of the vehicle, a discharge routine that is likely to counteract such expedited degradation.

CLAUSE 10: The computer-implemented method of any preceding clause, wherein the discharge routine comprises a recommended time or date determined by the second machine learning model to be suitable for periodic discharging of the battery, and wherein the discharge routine further comprises a recommended discharge amount to be periodically discharged at the recommended time or date.

CLAUSE 11: The computer-implemented method of any preceding clause, further comprising: visually rendering, by the device, the discharge routine on an electronic display.

CLAUSE 12: The computer-implemented method of any preceding clause, further comprising: visually rendering, by the device and on the electronic display, a reward associated with the discharge routine.

CLAUSE 13: The computer-implemented method of any preceding clause, wherein the vehicle is docked at a vehicular charging station, and further comprising: causing, by the device, the battery to discharge the recommended discharge amount to the vehicular charging station at the recommended time or date.

CLAUSE 14: The computer-implemented method of any preceding clause, wherein the vehicle is equipped with autonomous driving controls, and further comprising: causing, by the device and via the autonomous driving controls, the vehicle to travel to and dock at the vehicular charging station prior to the recommended time or date.

In various cases, any suitable combination or combinations of clauses 8 to 14 can be implemented.

CLAUSE 15: A computer program product for facilitating strategic discharging of vehicular batteries, the computer program product comprising a non-transitory computer-readable memory having program instructions embodied therewith, wherein the program instructions are executable by a processor, and wherein execution of the program instructions causes the processor to: access a charging history of a battery of a vehicle; and determine, via execution of a first machine learning model on the charging history, whether the battery is likely to experience expedited degradation.

CLAUSE 16: The computer program product of any preceding clause, wherein the program instructions are further executable to cause the processor to: recommend, in response to a determination that the battery is likely to experience expedited degradation and via execution of a second machine learning model on the charging history and on a driving history of the vehicle, a discharge routine that is likely to counteract such expedited degradation.

CLAUSE 17: The computer program product of any preceding clause, wherein the discharge routine comprises a recommended time or date determined by the second machine learning model to be suitable for periodic discharging of the battery, and wherein the discharge routine further comprises a recommended discharge amount to be periodically discharged at the recommended time or date.

CLAUSE 18: The computer program product of any preceding clause, wherein the program instructions are further executable to cause the processor to: visually render the discharge routine and a reward associated with the discharge routine on an electronic display.

CLAUSE 19: The computer program product of any preceding clause, wherein the vehicle is docked at a vehicular charging station, and wherein the program instructions are further executable to cause the processor to: cause the battery to discharge the recommended discharge amount to the vehicular charging station at the recommended time or date.

CLAUSE 20: The computer program product of any preceding clause, wherein the vehicle is equipped with autonomous driving controls, and wherein the program instructions are further executable to cause the processor to: cause, via the autonomous driving controls, the vehicle to travel to and dock at the vehicular charging station prior to the recommended time or date.

In various cases, any suitable combination or combinations of clauses 15 to 20 can be implemented.

In various cases, any suitable combination or combinations of clauses 1 to 20 can be implemented.

## Claims

1. A system, comprising:
a processor that executes computer-executable components stored in a non-transitory computer-readable memory, the computer-executable components comprising:
an access component that accesses a charging history of a battery of a vehicle; and
a degradation component that determines, via execution of a first machine learning model on the charging history, whether the battery is likely to experience expedited degradation.

2. The system of claim 1, wherein the computer-executable components further comprise:
a discharge component that recommends, in response to a determination that the battery is likely to experience expedited degradation and via execution of a second machine learning model on the charging history and on a driving history of the vehicle, a discharge routine that is likely to counteract such expedited degradation.

3. The system of claim 2, wherein the discharge routine comprises a recommended time or date determined by the second machine learning model to be suitable for periodic discharging of the battery, and wherein the discharge routine further comprises a recommended discharge amount to be periodically discharged at the recommended time or date.

4. The system of claim 3, wherein the discharge component visually renders the discharge routine on an electronic display.

5. The system of claim 4, wherein the discharge component visually renders on the electronic display a reward associated with the discharge routine.

6. The system of claim 3, wherein the vehicle is docked at a vehicular charging station, and wherein the computer-executable components further comprise:
an execution component that causes the battery to discharge the recommended discharge amount to the vehicular charging station at the recommended time or date.

7. The system of claim 6, wherein the vehicle is equipped with autonomous driving controls, and wherein the execution component causes, via the autonomous driving controls, the vehicle to travel to and dock at the vehicular charging station prior to the recommended time or date.

8. A computer-implemented method, comprising:
accessing, by a device operatively coupled to a processor, a charging history of a battery of a vehicle; and
determining, by the device and via execution of a first machine learning model on the charging history, whether the battery is likely to experience expedited degradation.

9. The computer-implemented method of claim 8, further comprising:
recommending, by the device, in response to a determination that the battery is likely to experience expedited degradation, and via execution of a second machine learning model on the charging history and on a driving history of the vehicle, a discharge routine that is likely to counteract such expedited degradation.

10. The computer-implemented method of claim 9, wherein the discharge routine comprises a recommended time or date determined by the second machine learning model to be suitable for periodic discharging of the battery, and wherein the discharge routine further comprises a recommended discharge amount to be periodically discharged at the recommended time or date.

11. The computer-implemented method of claim 10, further comprising:
visually rendering, by the device, the discharge routine on an electronic display.

12. The computer-implemented method of claim 11, further comprising:
visually rendering, by the device and on the electronic display, a reward associated with the discharge routine.

13. The computer-implemented method of claim 10, wherein the vehicle is docked at a vehicular charging station, and further comprising:
causing, by the device, the battery to discharge the recommended discharge amount to the vehicular charging station at the recommended time or date.

14. A computer program product for facilitating strategic discharging of vehicular batteries, the computer program product comprising a non-transitory computer-readable memory having program instructions embodied therewith, wherein the program instructions are executable by a processor, and wherein execution of the program instructions causes the processor to:
access a charging history of a battery of a vehicle; and
determine, via execution of a first machine learning model on the charging history, whether the battery is likely to experience expedited degradation.

15. The computer program product of claim 14, wherein the program instructions are further executable to cause the processor to:
visually render a discharge routine and a reward associated with the discharge routine on an electronic display.
